# EUROPEAN PATENT APPLICATION

(11) **EP 4 803 324 A1**
(43) Date of publication of application: **09.09.2026**
(21) Application number: 24885626.2
(22) Date of filing: 25.10.2024
(51) Int. Cl.: B41N 1/14, B41C 1/10, B41M 1/06, G03F 7/00, G03F 7/004, G03F 7/09, G03F 7/11

(54) **ON-PRESS DEVELOPMENT TYPE LITHOGRAPHIC PRINTING PLATE PRECURSOR, METHOD FOR PRODUCING LITHOGRAPHIC PRINTING PLATE, AND PRINTING METHOD**

(30) Priority: 31.10.2023 JP 2023186929
(71) Applicant: FUJIFILM Corporation, Tokyo 106-8620 (JP)
(72) Inventor: MATSUURA, Atsushi, Haibara-gun, Shizuoka 421-0396 (JP); MIYAGAWA, Yuya, Haibara-gun, Shizuoka 421-0396 (JP); AOSHIMA, Norio, Haibara-gun, Shizuoka 421-0396 (JP)
(74) Representative: HGF
(86) International application number: PCT/JP2024/038196
(87) International publication number: WO 2025/094853

(57) **Abstract**

An object of the present invention is to provide an on-press development type planographic printing plate precursor having excellent printing durability, a method of preparing a planographic printing plate, and a printing method. The on-press development type planographic printing plate precursor of the present invention is an on-press development type planographic printing plate precursor including a support; and an image recording layer, in which the support has an aluminum plate and an anodized film disposed on the aluminum plate, the anodized film has a plurality of micropores extending in a depth direction from a surface on a side of the image recording layer, the micropores have large-diameter pore portions extending from the surface of the anodized film to a position at a depth of 0.05 to 0.50 µm and small-diameter pore portions communicating with bottom portions of the large-diameter pore portions and extending in the depth direction from communication positions, an average diameter of the large-diameter pore portions on the surface of the anodized film is 0.015 to 0.070 µm, and an average value of Si atomic amounts calculated in a case where a circular region having a diameter of 30 mm on the surface of the anodized film on the side of the image recording layer is measured by X-ray fluorescence analysis is 0.008 to 0.14 mg.

## Description

### BACKGROUND OF THE INVENTION

### 1. Field of the Invention

The present invention relates to an on-press development type planographic printing plate precursor, a method of manufacturing a planographic printing plate, and a printing method.

### 2. Description of the Related Art

Planographic printing is a method of printing an image by setting a lipophilic image area of a planographic printing plate as an ink receiving area and a hydrophilic non-image area of the planographic printing plate as a dampening water receiving area (ink non-receiving area) using the property in which water and oily ink repel each other, causing a difference in adhesiveness of ink to the surface of the planographic printing plate, allowing the ink to be impressed only on an image area, and transferring the ink to a printing medium such as paper. In order to produce the planographic printing plate having the lipophilic image area and the hydrophilic non-image area, a planographic printing plate precursor (PS plate) in which a lipophilic photosensitive resin layer (image recording layer) is provided on a hydrophilic support has been widely used. Normally, the planographic printing plate precursor is manufactured by a method of remaining a portion, which is an image area of the image recording layer, after subjecting the planographic printing plate precursor to be exposed through an original image such as a lith film, dissolving and removing other unnecessary image recording layers with an alkaline developer or an organic solvent, and forming a non-image area by exposing a hydrophilic surface of the support.

Due to growing interest in global environment, issues related to waste liquid associated with a wet treatment such as a development treatment have been attracting attention.
In order to solve the above-described problem, there is a tendency to simplify or eliminate the development or plate-making, and a method called "on-press development" is performed as one of the countermeasures. That is, the on-press development is a method of exposing the planographic printing plate precursor, mounting the planographic printing plate precursor in a printing press without performing the development treatment, and then removing unnecessary portions of the image recording layer at an initial stage of a printing process.

Examples of the planographic printing plate precursor used for such an on-press development include a planographic printing plate precursor disclosed in JP2005-014348A.

JP2005-014348A describes a planographic printing plate precursor that has an image recording layer containing an infrared absorber, a polymerization initiator, and a polymerizable compound and capable of being removed by a printing ink and/or dampening water on an aluminum support subjected to an alkali metal silicate treatment, in which an adhesion amount of a Si element in the alkali metal silicate treatment to a surface of the aluminum support is 1 mg/m² or more and less than 10 mg/m².

### SUMMARY OF THE INVENTION

The present inventors have studied the properties of the planographic printing plate precursor described in JP2005-014348A and have found that when this planographic printing plate precursor is used, it may not satisfy the higher level of printing durability that is currently required, and that there is room for further improvement in the printing durability of the planographic printing plate precursor.

In view of the above circumstances, an object of the present invention is to provide an on-press development type planographic printing plate precursor having excellent printing durability. Another object of the present invention is to provide a manufacturing method of a planographic printing plate and a printing method.

The present inventors have found that the above-described objects can be achieved by the following configurations.
[1]
   An on-press development type planographic printing plate precursor comprising: a support; and an image recording layer, in which the support has an aluminum plate and an anodized film disposed on the aluminum plate, the anodized film has a plurality of micropores extending in a depth direction from a surface on a side of the image recording layer, the micropores have large-diameter pore portions extending from the surface of the anodized film to a position at a depth of 0.05 to 0.50 µm and small-diameter pore portions communicating with bottom portions of the large-diameter pore portions and extending in the depth direction from communication positions, an average diameter of the large-diameter pore portions on the surface of the anodized film is 0.015 to 0.070 µm, and an average value of Si atomic amounts calculated in a case where a circular region having a diameter of 30 mm on the surface of the anodized film on the side of the image recording layer is measured by X-ray fluorescence analysis is 0.008 to 0.14 mg.
[2] The on-press development type planographic printing plate precursor according to [1], in which a density of the micropores on the surface of the anodized film is 200 to 2,000 pores/µm2.
[3] The on-press development type planographic printing plate precursor according to [1] or [2], in which a ratio of an average maximum diameter inside the large-diameter pore portions to the average diameter of the large-diameter pore portions on the surface of the anodized film is 1.2 to 10.0.
[4] The on-press development type planographic printing plate precursor according to any one of [1] to [3], further comprising: an undercoat layer disposed between the support and the image recording layer, in which the undercoat layer contains a polymer having a support-adsorbing group and a hydrophilic group.
[5] The on-press development type planographic printing plate precursor according to [4], in which the polymer has a support-adsorbing group, a hydrophilic group, and a polymerizable group.
[6] The on-press development type planographic printing plate precursor according to [4] or [5], in which the hydrophilic group has a zwitterionic structure.
[7] The on-press development type planographic printing plate precursor according to any one of [1] to [6], in which the image recording layer contains an infrared absorber.
[8] The on-press development type planographic printing plate precursor according to [7], in which the infrared absorber has a substituent that is cleaved by infrared rays or heat.
[9] The on-press development type planographic printing plate precursor according to any one of [1] to [8], in which the image recording layer contains a borate compound.
[10] The on-press development type planographic printing plate precursor according to any one of [1] to [9], in which the image recording layer contains an acid color forming agent.
[11] The on-press development type planographic printing plate precursor according to any one of [1] to [10], in which an average value of Si atomic amounts calculated in a case where a circular region having a diameter of 30 mm on the surface of the anodized film on the side of the image recording layer is measured by X-ray fluorescence analysis is 0.010 to 0.080 mg.
[12] The on-press development type planographic printing plate precursor according to any one of [1] to [11], in which an average value of Si atomic amounts calculated in a case where a circular region having a diameter of 30 mm on the surface of the anodized film on the side of the image recording layer is measured by X-ray fluorescence analysis is 0.011 to 0.060 mg.
[13] A manufacturing for manufacturing a planographic printing plate, comprising: comprising: an exposure step of exposing the image recording layer of the on-press development type planographic printing plate precursor according to [1] or [12] in an imagewise manner to form an exposed portion and a non-exposed portion; and an on-press development step of supplying at least one of a printing ink or a dampening water on a printing press to remove the non-exposed portion of the imagewise-exposed image recording layer and to manufacture a planographic printing plate.
[14] A printing method comprising: an exposure step of an exposure step of exposing the image recording layer of the on-press development type planographic printing plate precursor according to any one of [1] to [12] in an imagewise manner to form an exposed portion and a non-exposed portion; an on-press development step of supplying at least one of a printing ink or a dampening water on a printing press to remove the non-exposed portion of the imagewise-exposed image recording layer and to manufacture a planographic printing plate; and a printing step of performing printing using the manufactured planographic printing plate.

According to the present invention, it is possible to provide an on-press development type planographic printing plate precursor having excellent printing durability. In addition, according to the present invention, it is possible to provide a manufacturing method of a planographic printing plate and a printing method.

### BRIEF DESCRIPTION OF THE DRAWINGS

FIG. 1 is a schematic cross-sectional view showing an example of a configuration of an on-press development type planographic printing plate precursor according to an embodiment of the present invention.
FIG. 2 is a schematic cross-sectional view showing an example of an embodiment of an anodic oxide film.
FIG. 3 is a schematic cross-sectional view showing another example of the embodiment of the anodic oxide film.
FIG. 4 is a graph showing an example of a waveform diagram of an alternating current waveform used for a hydrochloric acid electrolytic treatment in a manufacturing method of a support.
FIG. 5 is a side view showing an example of a radial type cell used for a hydrochloric acid electrolytic treatment using an alternating current in the manufacturing method of a support.
FIG. 6 is a schematic view of an anodization treatment device used in an anodization treatment in the manufacturing of the support.

### DESCRIPTION OF THE PREFERRED EMBODIMENTS

Hereinafter, the present invention will be described in detail.

Although configuration requirements to be described below are described based on representative embodiments of the present invention, the present invention is not limited to the embodiments.

In the present specification, the numerical range expressed by using "to" means a range including the numerical values before and after "to" as the lower limit value and the upper limit value.

In the present specification, "(meth)acryl" is a term that is used in a concept including both acrylic and methacryl, and "(meth)acryloyl" is a term that is used in a concept including both acryloyl and methacryloyl.

A term "step" in the present specification includes not only an independent step but also a step that cannot be clearly distinguished from other steps, as long as the intended purpose of the step is achieved.

Unless otherwise specified, each of values of physical properties is measured at 25°C.

Unless otherwise specified, each component in a composition or each constitutional unit in a polymer in the present specification may be contained alone or in combination of two or more kinds thereof.

In the present specification, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

In the present specification, a combination of two or more preferred aspects is a more preferred aspect.

A weight-average molecular weight (Mw) and a number-average molecular weight (Mn) in the present specification are molecular weights in terms of polystyrene used as a standard substance, which are detected by a molecular weight of a target compound in a solvent using tetrahydrofuran (THF), a differential refractometer, and a gel permeation chromatography (GPC) analyzer using TSKgel GMHxL, TSKgel G4000HxL, and TSKgel G2000HxL (all product names manufactured by Tosoh Corporation) as columns, unless otherwise specified.

In the present specification, a term "planographic printing plate precursor" includes not only a planographic printing plate precursor but also a key plate precursor. In addition, the term "planographic printing plate" includes not only a planographic printing plate produced by performing operations such as exposure and development, on a planographic printing plate precursor as necessary but also a key plate. In a case of the key plate precursor, operations of exposure and development are not necessarily required. In addition, a key plate is a planographic printing plate precursor for attachment to a plate cylinder which is not used, for example, in a case where printing is performed on a part of a paper surface with one or two colors in color newspaper printing.

In the present specification, a term "on-press development-type" means that the planographic printing plate precursor can be used for on-press development.

In the present specification, "excellent printing durability" means that the number of sheets which can be printed using the planographic printing plate is large.

### [On-press development type planographic printing plate precursor]

An on-press development type planographic printing plate precursor according to an embodiment of the present invention is an on-press development type planographic printing plate precursor including a support and an image recording layer, in which the support includes an aluminum plate and an anodic oxide film disposed on the aluminum plate.

In addition, the anodic oxide film has a plurality of micropores extending in a depth direction from a surface on an image recording layer side, and the micropore has a large-diameter pore portion having a predetermined shape and a small-diameter pore portion communicating with a bottom portion of the large-diameter pore portion and extending in the depth direction from a communication position.

Furthermore, an average value of Si atomic amounts calculated in a case where the surface of the anodic oxide film on the image recording layer side is measured by X-ray fluorescence analysis is 0.008 to 0.14 mg.

Hereinafter, a configuration of an on-press development type planographic printing plate precursor (hereinafter, also simply referred to as "planographic printing plate precursor") of an embodiment of the present invention will be described with reference to the accompanying drawings.

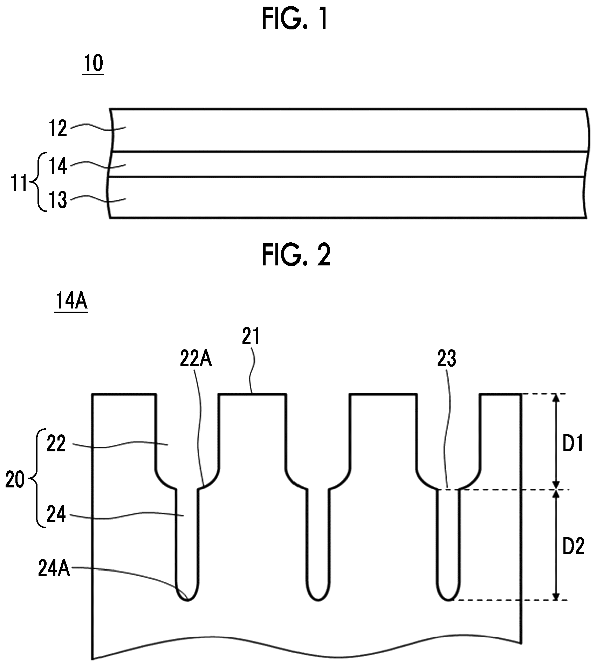

FIG. 1 is a schematic cross-sectional view showing an example of a configuration of the planographic printing plate precursor according to the embodiment of the present invention.

A planographic printing plate precursor 10 shown in FIG. 1 has a support 11 and an image recording layer 12. The support 11 includes an aluminum plate 13 and an anodic oxide film 14 disposed on the aluminum plate 13.

The configuration of the planographic printing plate precursor is not limited to the aspect shown in FIG. 1. For example, as will be described later, an undercoat layer may be provided between the support and the image recording layer, or a protective layer may be provided on a surface of the image recording layer on a side opposite to the support.

### [Support]

The planographic printing plate precursor according to the embodiment of the present invention includes a support including an aluminum plate and an anodic oxide film disposed on the aluminum plate.

The anodic oxide film in the support is located on the image recording layer side. That is, the planographic printing plate precursor includes the aluminum alloy plate, the anodic oxide film, and the image recording layer in this order.

Hereinafter, the term "support" means a support including an aluminum plate and an anodic oxide film disposed on the aluminum plate, unless otherwise specified.

### <Aluminum Sheet>

The aluminum plate is made of a metal containing aluminum having stable dimensions as a main component, and examples of the metal include aluminum and an aluminum alloy.

With regard to the aluminum plate, reference can be made to the aluminum plate described in WO2023/032992A, the description of which is incorporated herein by reference.

### <Anodized film>

The anodic oxide film included in the support is a film produced on the surface of the aluminum plate by an anodization treatment.

The amount of the anodic oxide film is not particularly limited, but from the viewpoint of more excellent scratch resistance, it is preferably 2.0 g/m² or more, more preferably 3.2 g/m² or more, and still more preferably 3.4 g/m² or more. The upper limit thereof is not particularly limited, but is often 5.0 g/m² or less, preferably 4.0 g/m² or less.

### (Micropore)

The anodic oxide film has a plurality of micropores (fine pores) formed on a surface of the anodic oxide film on the image recording layer side (hereinafter, also referred to as "film surface"). The micropore extends along a depth direction (direction toward the aluminum alloy plate; a thickness direction) from the film surface. A large number of micropores are formed on the film surface, and each of the micropores is often uniformly distributed on the film surface.

The "micropore" is a term generally used to refer to a pore structure formed in an anodic oxide film by an anodization treatment, and does not define a size of the pore.

In the present invention, the micropores formed in the anodic oxide film included in the support have a pore structure (hereinafter, also referred to as "specific structure") in which a large-diameter pore portion extending to a position at a depth of 0.05 to 0.5 µm from the film surface and a small-diameter pore portion communicating with a bottom portion of the large-diameter pore portion and extending from a communication position in the depth direction are provided, and an average diameter d1 of the large-diameter pore portion on the film surface is 0.015 to 0.1 µm.

Hereinafter, the specific structure of the micropores will be described in more detail with reference to the drawings. The specific structure of the micropores included in the anodic oxide film in the present invention is not limited to the aspect shown in the drawings.

FIG. 2 is a schematic cross-sectional view showing an example of an embodiment of the anodic oxide film. An anodic oxide film 14A shown in FIG. 2 has a micropore 20 composed of a large-diameter pore portion 22 and a small-diameter pore portion 24.

The large-diameter pore portion 22 is a hole portion extending to a position at a depth D1 from a film surface 21 (a surface of the anodic oxide film 14A on an image recording layer side, not shown), and communicates with the small-diameter pore portion 24 at a bottom portion 22A. The small-diameter pore portion 24 is a hole portion communicating with the bottom portion 22A of the large-diameter pore portion 22 and extending to a position at a depth D2 from a communication position 23.

An average diameter d1 (average opening diameter) of the large-diameter pore portion 22 on the film surface 21 is 0.015 to 0.070 µm. In a case where the average diameter d1 of the large-diameter pore portion 22 on the film surface 21 is within the above-described range, the printing durability of the on-press development type planographic printing plate precursor is more excellent.

From the viewpoint that the printing durability is more excellent, the average diameter d1 of the large-diameter pore portion 22 on the film surface 21 is more preferably 0.020 to 0.050 µm and still more preferably 0.022 to 0.040 µm.

The average diameter d1 of the large-diameter pore portion of the micropores on the film surface is a value obtained by observing the film surface with a field emission scanning electron microscope (FE-SEM) at a magnification of 150,000 times, randomly selecting a measurement region of 400 × 600 nm² in four images obtained by the observation at four different points, measuring the diameters of 50 micropores present in the measurement region of each image, and arithmetically averaging the measured values at 200 measurement points obtained from the four images.

In a case where the shape of the opening portion of the large-diameter pore portion of the micropores on the film surface is not circular, the opening diameter of each micropore is obtained by measuring the distance between two points having the maximum distance among two points present on the outer periphery of the opening portion.

A depth D1 of the large-diameter pore portion (a distance from the film surface 21 to the bottom portion 22A) is 0.05 to 0.50 µm, and from the viewpoint that the printing durability is more excellent, it is preferably 0.08 to 0.30 µm and more preferably 0.10 to 0.30 µm.

The depth D1 of the large-diameter pore portion, a depth D2 of the small-diameter pore portion described below, and a depth of the micropores described below are values obtained by observing a cross section of the micropores along a depth direction of the anodic oxide film with a FE-SEM at a magnification of 150,000 times, randomly selecting 25 or more micropores from four observation images obtained by the observation of four different cross sections, measuring the depths of the selected micropores, the large-diameter pore portion, and the small-diameter pore portion, and arithmetically averaging the measured values.

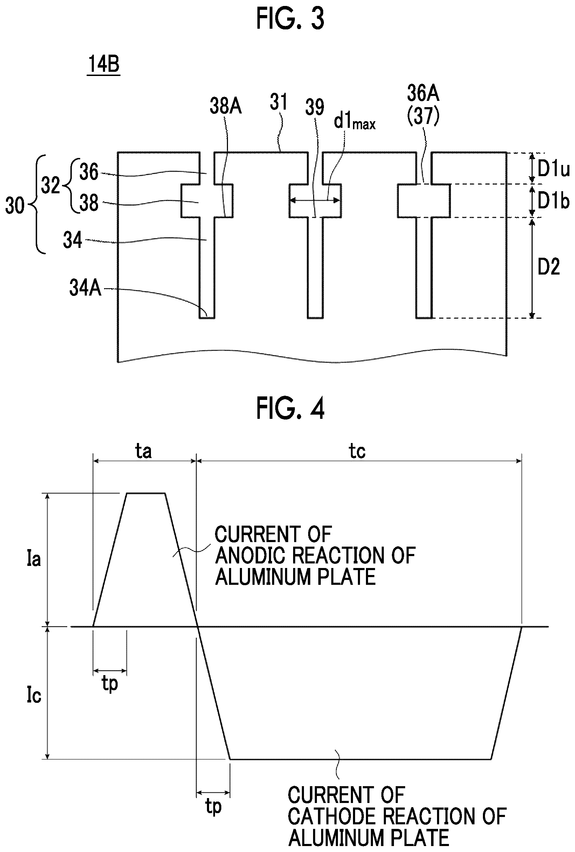

The shape of the large-diameter pore portion is not limited to the substantially straight tubular shape (substantially cylindrical shape) shown in FIG. 2, and the diameter of the large-diameter pore portion may be changed continuously or discontinuously in the depth direction. Examples of the shape in which the diameter of the large-diameter pore portion is changed in the depth direction include a tapered shape in which the diameter decreases in the depth direction, a tapered shape in which the diameter increases in the depth direction, and a shape in which a plurality of hole portions having different diameters in the depth direction communicate with each other (see FIG. 3). The shape of the large-diameter pore portion is preferably substantially straight tubular.

The shape of the bottom portion of the large-diameter pore portion is not particularly limited, and may be a curved shape (convex shape) such as the bottom portion 22A shown in FIG. 2 or a planar shape.

It is also preferable that the shape of the large-diameter pore portion is a shape having an internal maximum diameter portion having a pore diameter larger than an average diameter of the film surface in an internal region positioned at a position deeper than the film surface.

Examples of the shape having the internal maximum diameter portion include a shape in which a plurality of hole portions having different diameters along the depth direction from the film surface communicate with each other as in an anodic oxide film 14B shown in FIG. 3 described below, and a tapered shape in which the diameter increases in the depth direction.

In a case where the large-diameter pore portion has the internal maximum diameter portion, a ratio (d1ₘₐₓ/d1) of an average maximum diameter d1ₘₐₓ (see FIG. 3) inside the large-diameter pore portion to an average diameter d1 of the large-diameter pore portion on the film surface is preferably 1.1 to 10.0 and more preferably 1.1 to 5.0.

The average maximum diameter d1ₘₐₓ inside the large-diameter pore portion is a value obtained by observing a cross section of the micropores along the depth direction of the anodic oxide film with a FE-SEM at a magnification of 150,000 times, randomly selecting 25 micropores from four observation images obtained by the observation of four different cross sections, measuring the maximum diameters of the large-diameter pore portions in the anodic oxide film inside the selected micropores, and arithmetically averaging the measured values.

The small-diameter pore portion 24 is a hole portion which communicates with the bottom portion 22A of the large-diameter pore portion 22 and further extends from the communication position 23 in the depth direction. In the micropore 20 shown in FIG. 2, one large-diameter pore portion 22 communicates with one small-diameter pore portion 24, but the micropore may have two or more small-diameter pore portions communicating with one large-diameter pore portion.

The average diameter d2 of the small-diameter pore portion 24 at the communication position 23 is not particularly limited as long as it is smaller than the average diameter d1 of the large-diameter pore portion 22 on the film surface, but from the viewpoint of more excellent on-press developability, it is preferably 15 nm or less, more preferably 13 nm or less, still more preferably 11 nm or less, and particularly preferably 10 nm or less. The lower limit thereof is not particularly limited, but is preferably 5 nm or more.

The average diameter d2 of the small-diameter pore portion at the communication position is a value obtained by observing a cross section of the micropores along the depth direction of the anodic oxide film with a field emission scanning electron microscope (FE-SEM) at a magnification of 150,000 times, randomly selecting 20 points from four images in four images obtained by the observation at four different positions, measuring the pore diameters (diameters) of the small-diameter pore portions at the communication position, and arithmetically averaging all the measured values.

From the viewpoint of achieving both scratch resistance and productivity, a depth D2 of the small-diameter pore portion 24 (distance from the communication position 23 with the large-diameter pore portion 22 to the bottom portion 24A of the small-diameter pore portion 24) is preferably 0.1 to 5 µm, more preferably 0.2 to 4 µm, still more preferably 0.3 to 3 µm, and particularly preferably 0.5 to 1.8 µm.

A shape of the small-diameter pore portion is not limited to the substantially straight tubular shape (substantially cylindrical shape) shown in FIG. 2, and may be, for example, a conical shape in which the diameter decreases in the depth direction or a frustum shape in which the diameter increases in the depth direction. The shape of the small-diameter pore portion is preferably substantially straight tubular.

The shape of the bottom portion of the small-diameter pore portion is not particularly limited, and may be a curved shape (convex shape) as in the bottom portion 24A shown in FIG. 2 or a planar shape.

A ratio (d1/d2) of the average diameter d1 of the large-diameter pore portion 22 on the film surface 21 to the average diameter d2 of the small-diameter pore portion 24 at the communication position 23 is preferably 1.1 to 13 and more preferably 1.5 to 6.5.

In addition, a ratio (D1/D2) of the depth D1 of the large-diameter pore portion 22 to the depth D2 of the small-diameter pore portion 24 is preferably 0.005 to 50 and more preferably 0.025 to 40.

FIG. 3 is a schematic cross-sectional view showing another example of the embodiment of the anodic oxide film. An anodic oxide film 14B shown in FIG. 3 has micropores 30 composed of large-diameter pore portions 32 and small-diameter pore portions 34. In addition, the large-diameter pore portion 32 is composed of a large-diameter pore portion upper portion 36 and a large-diameter pore portion lower portion 38. In the micropores 30, the large-diameter pore portion upper portion 36, the large-diameter pore portion lower portion 38, and the small-diameter pore portion 34 communicate with each other.

The large-diameter pore portion upper portion 36 is a hole portion extending to a position at a depth D1u from the film surface 31 (a surface of the anodic oxide film 14B on the image recording layer side, not shown), and communicates with the large-diameter pore portion lower portion 38 at a bottom portion 36A.

The large-diameter pore portion lower portion 38 is a portion corresponding to the above-described internal maximum diameter portion, is a hole portion communicating with the bottom portion 36A of the large-diameter pore portion upper portion 36 and extending to a position at a depth D1b from a communication position 37 with the large-diameter pore portion upper portion 36, and communicates with the small-diameter pore portion 34 at a bottom portion 38A.

The small-diameter pore portion 34 is a hole portion communicating with the bottom portion 38A of the large-diameter pore portion lower portion 38 and extending to the bottom portion 36A at a position at a depth D2 from a communication position 39 with the large-diameter pore portion lower portion 38.

An average diameter of the large-diameter pore portion upper portion 36 on the film surface 31 is the same as the average diameter of the large-diameter pore portion on the film surface, and a preferred range of the average diameter and a measuring method are also the same.

A total of the depth D1u of the large-diameter pore portion upper portion 36 (a distance from the film surface 31 to the bottom portion 36A) and the depth D1b of the large-diameter pore portion lower portion 38 (a distance from the bottom portion 36A to the bottom portion 38A) corresponds to the depth D1 of the large-diameter pore portion, and is 0.05 to 0.5 µm.

From the viewpoint of achieving both the on-press developability and the printing durability, the depth D1u of the large-diameter pore portion upper portion 36 is preferably 0.02 to 0.2 µm and more preferably 0.05 to 0.1 µm.

In addition, from the viewpoint of achieving both the on-press developability and the printing durability, the depth D1b of the large-diameter pore portion lower portion 38 is preferably 0.05 to 0.3 µm and more preferably 0.05 to 0.2 µm.

The depth D1u of the large-diameter pore portion upper portion 36 and the depth D1b of the large-diameter pore portion lower portion 38 can be measured according to the above-described measuring method of the depth D1 of the large-diameter pore portion.

A shape of the large-diameter pore portion is not limited to the substantially straight tubular shape (substantially cylindrical shape) shown in FIG. 3, and may be, for example, a conical shape in which the diameter decreases in the depth direction or a frustum shape in which the diameter increases in the depth direction. The shape of the large-diameter pore portion upper portion is preferably the substantially straight tubular shape.

The large-diameter pore portion lower portion 38 is a hole portion that communicates with the bottom portion 36A of the large-diameter pore portion upper portion 36 and further extends in the depth direction from the communication position 37. As shown in FIG. 3, a maximum diameter of the large-diameter pore portion lower portion 38 corresponds to the maximum diameter d1ₘₐₓ inside the large-diameter pore portion 32.

From the viewpoint of achieving both the on-press developability and the printing durability, the maximum diameter of the large-diameter pore portion lower portion 38 is preferably 0.02 to 0.2 µm, more preferably 0.03 to 0.1 µm, and still more preferably 0.04 to 0.08 µm.

In addition, from the viewpoint of achieving both the on-press developability and the printing durability, a ratio of the maximum diameter of the large-diameter pore portion lower portion 38 to the average diameter of the large-diameter pore portion upper portion 36 on the film surface 31 ((Maximum diameter of large-diameter pore portion lower portion 38)/(Average diameter of large-diameter pore portion upper portion 36 on coating surface 31)) is preferably 1.2 to 10.0 and more preferably 1.2 to 5.0.

The maximum diameter of the large-diameter pore portion lower portion 38 can be measured according to the above-described measuring method of the average maximum diameter d1ₘₐₓ inside the large-diameter pore portion.

A shape of the large-diameter pore portion is not limited to the substantially straight tubular shape (substantially cylindrical shape) shown in FIG. 3, and may be, for example, a conical shape in which the diameter decreases in the depth direction or a frustum shape in which the diameter increases in the depth direction. The shape of the large-diameter pore portion lower portion is preferably the substantially straight tubular shape.

A shape of the bottom portion of the large-diameter pore portion lower portion is not particularly limited, and may be a curved shape (convex shape) or a planar shape.

The small-diameter pore portion 34 is a hole portion which communicates with the bottom portion 38A of the large-diameter pore portion 38 and further extends from the communication position 39 in the depth direction.

The shape and size of the small-diameter pore portion 34 are the same as those of the small-diameter pore portion 24 described above, including a preferred aspect.

The structure of the micropore in the anodic oxide film is not limited to the aspects shown in FIGS. 2 and 3.

For example, as described above, the large-diameter pore portion may have a structure in which three or more hole portions having different diameters along the depth direction communicate with each other.

A depth of the micropores is not particularly limited, but from the viewpoint of achieving both the on-press developability and the printing durability, it is preferably 0.01 to 1 µm, more preferably 0.05 to 0.6 µm, and still more preferably 0.07 to 0.25 µm. The depth of the micropore means a distance in the depth direction from the film surface of the micropore to the deepest portion of a bottom portion of the micropore.

A density of the micropores on the coating surface is not particularly limited, but from the viewpoint of achieving both the on-press developability and the printing durability, it is preferably 200 to 2,000 pieces/µm² and more preferably 400 to 1,500 pieces/µm².

The density of the micropores is a value obtained by observing the film surface with a field emission scanning electron microscope (FE-SEM) at a magnification of 150,000 times, randomly selecting a measurement region of 400 × 600 nm² in four images obtained by observing four different sites, measuring the number of micropores present in the measurement region, calculating the number of micropores per area of the measurement region for each image, and arithmetically averaging the calculated values.

An opening ratio of the micropores on the coating surface is preferably 10% to 90% and more preferably 30% to 85% from the viewpoint of achieving both the on-press developability and the printing durability.

The opening ratio is a value obtained by converting, into a percentage, a value obtained by multiplying an average area of the opening portion by the large-diameter pores of the micropores on the surface of the coating film, which is calculated by dividing the average diameter of the large-diameter pores of the micropores on the surface of the coating film by 2, by the density (number density) of the micropores on the surface of the coating film.

### (Si atomic weight)

In the planographic printing plate precursor according to the embodiment of the present invention, an average value of Si atomic weights (hereinafter, also referred to as "specific Si atomic weight") calculated in a case where a circular region having a diameter of 30 mm on the surface of the anodic oxide film of the support on the image recording layer side is measured by X-ray fluorescence analysis is 0.008 to 0.14 mg.

The present invention has been completed based on the finding of the present inventors that the printing durability of the planographic printing plate precursor can be further improved by providing the micropores formed in the anodic oxide film of the support with a specific structure consisting of a large-diameter pore portion having a depth of 0.05 to 0.5 µm from the coating surface and an average diameter d1 of 0.015 to 0.1 µm and a small-diameter pore portion communicating with a bottom portion of the large-diameter pore portion, and setting the specific Si atomic weight on the surface of the anodic oxide film within the above-described range.

The details of the mechanism by which the on-press development type planographic printing plate precursor according to the embodiment of the present invention has more excellent printing durability are not clear, but are presumed as follows. In the above-described aspect, on the surface of the anodic oxide film in which the micropores having the specific structure are formed, there is a possibility that not only the image recording layer is simply stacked on the surface of the appearance, but also a part of the image recording layer enters the inside of each micropore. Therefore, in the anodic oxide film in which the micropores having the specific structure are formed on the surface, the area in which the image recording layer is substantially in contact with the surface of the support is different from that in the anodic oxide film in which the micropores are not formed on the surface, and thus it is considered that the appropriate range of the Si amount with respect to the apparent surface is different.

In the planographic printing plate precursor according to the embodiment of the present invention, it is presumed that an on-press development type planographic printing plate precursor having excellent printing durability (particularly, printing durability under a harsh condition) can be provided by specifying the specific Si atomic weight on the coating surface within the above-described range corresponding to the anodic oxide film on which the micropores having the specific structure are formed on the surface.

The specific Si atomic amount is obtained by performing the fluorescence X-ray analysis on a circular region having a diameter of 30 mm on the surface of the coating film, measuring the intensity of the Kα ray of the Si element, and then quantifying the Si atomic amount present on the surface of the coating film using a calibration curve. Here, the "average value of Si atomic weights" means a numerical value obtained by selecting three or more circular regions that do not overlap each other on the surface of the anodic oxide film on the image recording layer side, obtaining the Si atomic weight for each region, and arithmetically averaging the obtained Si atomic weights of each of the regions.

Details of the method for measuring the specific Si atom amount by the fluorescence X-ray analysis will be described in Examples described later.

JP2005-014348A describes that, in a case where the adhesion amount of the Si element on the surface of the aluminum support subjected to an alkali metal silicate treatment exceeds 10 mg/m², the adhesiveness between the image recording layer and the aluminum support is decreased, and the printing durability is decreased. Since it is described that the adhesion amount is measured by X-ray fluorescence analysis, it is presumed that the adhesion amount is usually calculated by dividing the measured Si amount by the measurement area of the X-ray fluorescence analysis. Here, in a case where the adhesion amount of the Si element of 10 mg/m² described in JP2005-014348A is converted into the specific Si atomic weight in the circular region of 30 mm in the present case, the adhesion amount is calculated to be approximately 0.007 mg, which is not included in the range specified in the present invention. As shown in Comparative Examples 2 and 3 of Examples described later, in a case where the specific Si atomic weight is 0.007 mg, the requirement of the present invention is not satisfied, and the technique disclosed in JP2005-014348A does not solve the problem of the present invention.

From the viewpoint of achieving a balance among on-press developability, ink repellency, and printing durability, the specific Si atomic weight per circular region having a diameter of 30 mm on the surface of the anodic oxide film is preferably 0.08 to 0.14 mg, more preferably 0.010 to 0.080 mg, and still more preferably 0.011 to 0.060 mg.

Examples of the method of adjusting the specific Si atom amount on the surface of the anodic oxide film within the above-described range in the support of the planographic printing plate precursor include a method of adjusting the specific Si atom amount by changing any one of the concentration of the silicate, the temperature of the treatment liquid, or the treatment time in the silicate treatment which will be described later and which is performed on the formed anodic oxide film after the anodic oxide film having the micropores is formed on the aluminum plate.

### (Recessed portion density)

From the viewpoint of further improving the printing durability, the density of the concave portion (hereinafter, also referred to as "specific concave portion") having a depth of 0.7 µm or more from the average plane, which is obtained by measuring a range of 400 µm × 400 µm on the surface of the support on the anodic oxide film side using a noncontact three-dimensional roughness meter, is preferably 3,000 to 10,000 pieces/mm², more preferably 3,500 to 8,000 pieces/mm², and still more preferably 5,000 to 8,000 pieces/mm².

The density of the specific recessed portions in the support refers to a value measured as follows.

First, using a non-contact three-dimensional roughness meter (VertScan, manufactured by Ryoka Systems Inc.), three-dimensional data is obtained by scanning a surface of the support on the anodic oxide film side (image recording layer side) in a range of 400 µm × 400 µm in a non-contact manner with a resolution of 0.01 µm. The device contents and measurement conditions of VertScan are as follows.

### (1) Device contents

CCD camera: Sony HR-57
Objective lens: ×10
Lens barrel: ×1
Wavelength filter: 530 white

### (2) Measurement condition

Measurement mode: wave
Visual field range: 400 µm × 400 µm
Scan range: start + 6 µm, stop -10 µm

Next, the obtained three-dimensional data is subjected to image analysis using software (SX Viewer, manufactured by Ryoka Systems Inc.), and the number of recessed portions having a depth of 0.7 µm or more from the obtained average plane is counted. The average plane means a plane located at a height obtained by averaging height values of all measurement data of the surface of the support on the image recording layer side in the measurement region (400 µm × 400 µm).

The density of the specific recessed portions is obtained by measuring five sites for each sample, calculating the number of predetermined recesses at each site, acquiring the average value thereof, and converting the acquired average value into the number of recessed portions per unit area (mm²).

### (Specific surface area ΔS)

In the support, from the actual area Sx obtained by an approximate three-point method from three-dimensional data obtained by measuring 256 × 256 points in a range of 25 µm × 25 µm on the surface of the anodic oxide film side using an atomic force microscope and the geometrically measured area S0 of the surface of the anodic oxide film, the specific surface area ΔS calculated by the following expression (S1) is preferably 20% to 70% and more preferably 30% to 60% from the viewpoint that the printing durability is more excellent. $ΔS = \left(Sx-S0\right) / S 0 \times 100 \left(%\right)$

The specific surface area ΔS in the support refers to a value measured as follows. Specifically, the support is cut into a size of 1 cm² and set on a horizontal sample stand which is provided on a piezo scanner, a cantilever is allowed to approach the surface of the sample, the surface is scanned in an XY direction in a case where the cantilever reaches a region where an atomic force works, and the unevenness of the sample is captured by the displacement of the piezo in a Z direction. As the piezo scanner, a piezo scanner capable of performing scanning of 100 µm in the XY direction and 15 µm in the Z direction is used. As the cantilever, a cantilever (for example, "OMCL-AC200-TS" (manufactured by Olympus Corporation) and "SI-DF20" (manufactured by Nanoprobe, Inc.)) having a resonance frequency of 120 to 200 kHz and a spring constant of 7 to 20 N/m is used, and the measurement is performed in a dynamic force mode (DFM mode). In addition, by carrying out the least squares approximation of the acquired three-dimensional data, the slight inclination of the sample is corrected to acquire a reference surface.

During the measurement, 512 × 512 points in an area of 25 × 25 µm on the surface are measured. The resolution in the X direction is set to 0.05 µm, the resolution in the Y direction is set to 0.05 µm, the resolution in the Z direction is set to 1 nm, and the scanning speed is set to 18 µm/sec.

### (Brightness)

From the viewpoint of improving image visibility in the on-press development-type planographic printing plate precursor, it is useful that a brightness of the surface of the anodic oxide film in the support is high.

Usually, in a printing step using a planographic printing plate, before the printing plate is mounted on a printer, the plate is inspected to check whether an image is recorded as intended. For the on-press development type planographic printing plate precursor, it is required to check the image at the stage where the image is exposed. Therefore, a unit generating a so-called printed image in an image exposure portion is used.

Examples of a method of quantitatively evaluating ease of seeing the image area (visibility) of the on-press development-type planographic printing plate precursor imagewise exposed include a method of measuring the lightness of the image exposed portion and the lightness of a non-exposed portion and calculating a difference therebetween. Here, as the lightness, a value of lightness L^{*} in the CIE L^{*}a^{*}b^{*} color system can be used, and the lightness can be measured using a color difference meter (SpectroEye (registered trademark), manufactured by X-Rite, Inc.). The larger the difference between the measured brightness of the image exposure portion and the measured brightness of the non-exposed portion, the higher the visibility of the image area.

From the viewpoint of improving visibility, that is, increasing the difference between the lightness of the image-exposed portion and the lightness of the non-exposed portion, the value of lightness L^{*} in the L^{*}a^{*}b^{*} color system of the surface of the anodic oxide film is preferably 60 to 100 and more preferably 70 to 90.

The support may include, as necessary, a back coat layer containing an organic polymer compound described in JP1993-045885A (JP-H5-045885A), an alkoxy compound of silicon described in JP1994-035174A (JP-H6-035174A), or the like on the surface on the aluminum alloy plate side.

### <Manufacturing method of support>

The support used in the planographic printing plate precursor according to the embodiment of the present invention can be manufactured by a known method.

Examples of the manufacturing method of the support include a method including a roughening treatment step of subjecting an aluminum plate to a roughening treatment and an anodization treatment step of subjecting the aluminum plate subjected to the roughening treatment to an anodization treatment to form an anodic oxide film of aluminum on the aluminum plate.

Among these, a method further including a pore widening treatment step of subjecting the aluminum plate on which the anodic oxide film is formed to an etching treatment to enlarge the diameter of the micropores in the anodic oxide film and a second anodization treatment step of further subjecting the aluminum plate to an anodization treatment after the pore widening treatment after the anodization treatment step is preferable. In addition, a method further including a silicate treatment step of subjecting the aluminum plate having the anodic oxide film formed by the above-described treatment to a silicate treatment described later is also preferable.

Hereinafter, each step described above and optional treatments will be described in detail.

The aluminum plate used for manufacturing the support is as described above including the preferred aspect thereof.

### (Roughening treatment step)

The roughening treatment step is a step of subjecting the surface of the aluminum plate to a roughening treatment.

As the roughening treatment, generally, one of a mechanical roughening treatment, a chemical roughening treatment, or an electrochemical roughening treatment, or a combination of two or more of the treatments is used.

From the viewpoint of efficiently manufacturing a predetermined support, it is preferable that the roughening treatment step has a hydrochloric acid electrolytic treatment step of performing alternating current electrolysis on the aluminum alloy plate in a hydrochloric acid treatment liquid which may contain sulfuric acid, at a liquid temperature of the hydrochloric acid treatment liquid of 30°C or lower, a sum of electric quantities involved in an anodic reaction of the aluminum alloy plate of 500 C/dm² or less, and a peak current value of an alternating current waveform of 80 A/dm² or less, thereby producing a roughened aluminum alloy plate.

In a case where the hydrochloric acid treatment liquid contains sulfuric acid, a ratio of a content of sulfuric acid to a content of hydrochloric acid is preferably 0.1 or less.

### (Mechanical roughening treatment)

The manufacturing method of the support may include a mechanical roughening treatment before the hydrochloric acid electrolytic treatment step.

Examples of the mechanical roughening treatment method include a wire brush grain method of scratching the surface of the aluminum alloy plate with a metal wire; a ball grain method of graining the surface of the aluminum alloy plate with a polishing ball and an abrasive; and a brush grain method of graining the surface with a nylon brush and an abrasive, which is described in JP1994-135175A (JP-H6-135175A) and JP1975-040047B (JP-S50-040047B).

### (Hydrochloric acid electrolytic treatment step)

The hydrochloric acid electrolytic treatment step in the manufacturing method of the support is preferably a hydrochloric acid electrolytic treatment step of performing alternating current electrolysis on the aluminum alloy plate in a hydrochloric acid treatment liquid which may contain sulfuric acid, at a liquid temperature of the hydrochloric acid treatment liquid of 30°C or lower, a sum of electric quantities involved in an anodic reaction of the aluminum alloy plate of 500 C/dm² or less, and a peak current value of an alternating current waveform of 80 A/dm² or less, thereby producing a roughened aluminum alloy plate. By performing such a hydrochloric acid electrolytic treatment and then performing the anodization treatment described later, the above-described planographic printing plate precursor can be efficiently manufactured.

The hydrochloric acid treatment liquid contains hydrochloric acid. A concentration of the hydrochloric acid in the hydrochloric acid treatment liquid is preferably 5 to 30 g/L and more preferably 10 to 20 g/L.

The hydrochloric acid treatment liquid may contain sulfuric acid. In a case where the hydrochloric acid treatment liquid contains sulfuric acid, a concentration of the sulfuric acid in the hydrochloric acid treatment liquid is preferably 2.0 g/L or less, more preferably 1.0 g/L or less, and still more preferably 0.5 g/L. In a case where the hydrochloric acid treatment liquid contains sulfuric acid, the lower limit of the concentration of the sulfuric acid in the hydrochloric acid treatment liquid is not particularly limited, and may be more than 0 g/L.

The hydrochloric acid treatment liquid may contain aluminum ions. In a case where the hydrochloric acid treatment liquid contains aluminum ions, a concentration of the aluminum ions is preferably 1.0 to 30.0 g/L and more preferably 5.0 to 20.0 g/L.

In a case where the hydrochloric acid treatment liquid contains sulfuric acid, a ratio of the content of sulfuric acid to the content of hydrochloric acid is preferably 0.1 or less. The lower limit thereof is not particularly limited, and may be more than 0.

A liquid temperature of the hydrochloric acid treatment liquid is preferably 30°C or lower, more preferably 26°C or lower, and still more preferably 23°C or lower. The lower limit thereof is not particularly limited, but is preferably 10°C or higher and more preferably 15°C or higher.

In the hydrochloric acid electrolytic treatment step, the sum of electric quantities (the sum of electric quantities involved in an anodic reaction of the aluminum alloy plate at the time when the hydrochloric acid electrolytic treatment is completed) is preferably 500 C/dm² or less, and more preferably 350 C/dm² or less. The lower limit of the sum of electric quantities is not particularly limited, but is preferably 50 C/dm² or more and more preferably 200 C/dm² or more.

The peak current value of an alternating current waveform is preferably 80 A/dm² or less and more preferably 70 A/dm² or less. The above-described peak current value is preferably 10 A/dm² or more and more preferably 20 A/dm² or more.

The alternating current waveform of the hydrochloric acid electrolytic treatment may use a sine wave, a square wave, a trapezoidal wave, a triangular wave, or the like. A frequency thereof is preferably 0.1 to 250 Hz.

FIG. 4 is a graph showing an example of an alternating waveform current waveform diagram used for the hydrochloric acid electrolytic treatment.

In FIG. 4, ta represents an anode reaction time, tc represents a cathode reaction time, tp represents a time taken for the current to reach the peak from 0, Ia represents the peak current on an anode cycle side, and Ic represents the peak current on a cathode cycle side. In the trapezoidal wave, the time tp taken for the current to reach the peak from 0 is preferably 1 to 10 msec.

As the preferable conditions for one cycle of the alternating current used for the hydrochloric acid electrolytic treatment, a ratio tc/ta of the cathodic reaction time tc to the anodic reaction time ta of the aluminum plate is in a range of 1 to 20, a ratio Qc/Qa of an electric quantity Qc in a case of the aluminum plate serving as an anode to an electric quantity Qa in a case of the aluminum plate serving as an anode is in a range of 0.3 to 20, and the anodic reaction time ta is in a range of 5 to 1000 msec.

It is preferable that the peak current value is in the above-described range (80 A/dm² or less) in both the anode cycle side Ia and the cathode cycle side Ic of the current in terms of the peak value of the trapezoidal wave.

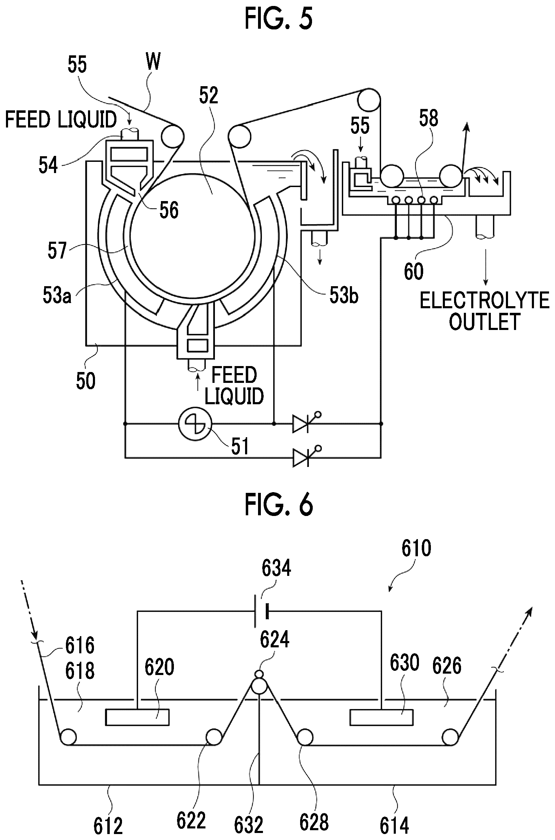

A device illustrated in FIG. 5 can be used for the hydrochloric acid electrolytic treatment carried out using the alternating current.

FIG. 5 is a side view showing an example of a radial type cell used for the hydrochloric acid electrolytic treatment using the alternating current.

In FIG. 5, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, and W represents an aluminum plate. In a case where two or more electrolytic cells are used, the electrolysis conditions may be the same or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W which has been treated in the main electrolytic cell 50 is electrolyzed in the auxiliary anode cell 60. The auxiliary anode 58 is disposed in the auxiliary anode cell 60 to face the aluminum plate W and the electrolytic solution 55 is supplied to flow through the space between the auxiliary anode 58 and the aluminum plate W.

### (Alkali etching treatment)

It is preferable that the manufacturing method of the support includes an alkali etching treatment after the above-described mechanical roughening treatment in a case of performing the mechanical roughening treatment, or before and after the above-described hydrochloric acid electrolytic treatment step.

In addition, the alkali etching treatment performed before the hydrochloric acid electrolytic treatment is performed for the purpose of removing rolling oil, stains, natural oxide films, and the like on the surface of the aluminum plate (rolled aluminum) in a case where the mechanical roughening treatment has not been performed and for the purpose of dissolving edge portions of unevenness generated by the mechanical roughening treatment to change the surface with steep unevenness to a surface with smooth undulations in a case where the mechanical roughening treatment has been performed.

In a case where the mechanical roughening treatment is not performed before the alkali etching treatment, an etching amount is preferably 0.1 to 10 g/m² and more preferably 1 to 5 g/m². In a case where the etching amount is 1 to 10 g/m², rolling oil, stains, natural oxide films, and the like on the surface are sufficiently removed.

In a case where the mechanical roughening treatment is performed before the alkali etching treatment, the etching amount is preferably 3 to 20 g/m² and more preferably 5 to 15 g/m².

The alkali etching treatment performed immediately after the hydrochloric acid electrolytic treatment is performed for the purpose of dissolving smut generated in an acidic electrolytic solution and dissolving edge portions of unevenness formed by the hydrochloric acid electrolytic treatment. Since unevenness formed by the hydrochloric acid electrolytic treatment varies depending on the type of the electrolytic solution, the optimum etching amount also varies, but the etching amount of the alkali etching treatment performed after the hydrochloric acid electrolytic treatment is preferably 0 to 0.5 g/m² and more preferably 0 to 0.3 g/m².

Examples of the alkali used in an alkaline solution include caustic alkali and an alkali metal salt. In particular, an aqueous solution of caustic soda is preferable.

A concentration of the alkaline solution can be determined depending on the etching amount, but is preferably 1% to 50% by mass and more preferably 10% to 35% by mass. In a case where aluminum ions are dissolved in the alkaline solution, a concentration of the aluminum ions is preferably 0.01% to 10% by mass and more preferably 3% to 8% by mass. A temperature of the alkaline solution is preferably 20°C to 90°C. A treatment time is preferably 0 to 120 seconds.

Examples of a method of bringing the aluminum plate into contact with the alkaline solution include a method of causing the aluminum plate to pass through a tank containing the alkaline solution, a method of immersing the aluminum plate in a tank containing the alkaline solution, and a method of spraying the alkaline solution onto the surface of the aluminum plate.

### (Desmutting treatment)

In the manufacturing method of the support, it is preferable that, after performing the hydrochloric acid electrolytic treatment or the alkali etching treatment, pickling (desmutting treatment) is performed to remove corrosive organisms remaining on the surface.

Examples of the acid used for the desmutting treatment include nitric acid, sulfuric acid, and hydrochloric acid, but other acids may be used.

The above-described desmutting treatment is performed, for example, by bringing the above-described aluminum alloy plate into contact with an acidic solution (containing 0.01% to 5% by mass of aluminum ions) in which a concentration of hydrochloric acid, nitric acid, sulfuric acid, or the like is 0.5% to 30% by mass.

Examples of a method of bringing the aluminum plate into contact with the acidic solution include a method of causing the aluminum plate to pass through a tank containing the acidic solution, a method of immersing the aluminum plate in a tank containing the acidic solution, and a method of spraying the acidic solution onto the surface of the aluminum plate.

Since a surface state of the aluminum alloy plate after the desmutting treatment affects the subsequent growth of the natural oxide film, the selection and concentration of the acid, and the temperature conditions are appropriately selected according to the purpose.

### (Water washing treatment)

In the manufacturing method of the support, it is preferable to perform water washing after the completion of each of the above-described steps. In particular, washing with water at the end of the step affects the subsequent growth of natural oxide films, and thus washing with water is required to be sufficiently performed using pure water, well water, tap water, or the like.

### (Anodization treatment step (first anodization treatment step))

The anodization treatment step is a step of subjecting the aluminum plate roughened by the above-described roughening treatment step to an anodization treatment to form an anodic oxide film of aluminum on the aluminum plate.

The anodization treatment step may be performed only once or may be performed a plurality of times.

A procedure of the anodization treatment step is not particularly limited, and examples thereof include known methods.

In the anodization treatment step, an aqueous solution of sulfuric acid, phosphoric acid, oxalic acid, and the like can be used as an electrolytic bath. For example, a concentration of sulfuric acid may be 100 to 300 g/L.

Conditions for the anodization treatment are appropriately set depending on the electrolytic solution, and examples thereof include a solution temperature of 5°C to 70°C (preferably 10°C to 60°C), a current density of 0.5 to 60 A/dm² (preferably 5 to 60 A/dm²), a voltage of 1 to 100 V (preferably 5 to 50 V), an electrolysis time of 1 to 100 seconds (preferably 5 to 60 seconds), and a coating amount of 0.1 to 5 g/m² (preferably 0.2 to 3 g/m²).

In the manufacturing method of the support, from the viewpoint of further improving adhesiveness between the support and the image recording layer, an aqueous solution containing sulfuric acid or phosphoric acid is preferable as an electrolytic bath used in the anodization treatment step.

### (Pore widening treatment step)

The above-described pore widening treatment step is a treatment (pore diameter expanding treatment) step of performing an etching treatment on the aluminum plate, on which the anodized film has been formed after the anodization treatment step described above, to expand the diameter of micropores in the anodized film.
The pore widening treatment can be carried out by bringing the aluminum plate obtained by the anodization treatment step into contact with an aqueous acid solution or an aqueous alkali solution. The method of bringing the aluminum plate into contact with the aqueous acid solution or the aqueous alkali solution is not particularly limited, and examples thereof include an immersion method and a spray method.

### (Second anodization treatment)

In the manufacturing method of a support, it is preferable to perform a second anodization treatment step of performing an anodization treatment after the above-described first anodization treatment and pore widening treatment.

A procedure of the anodization treatment step is not particularly limited, and examples thereof include known methods.

In the anodization treatment step, an aqueous solution of sulfuric acid, phosphoric acid, oxalic acid, and the like can be used as an electrolytic bath. For example, a concentration of sulfuric acid may be 100 to 300 g/L.

Conditions for the anodization treatment are appropriately set depending on the electrolytic solution, and examples thereof include a solution temperature of 5°C to 70°C (preferably 10°C to 60°C), a current density of 0.5 to 60 A/dm² (preferably 5 to 60 A/dm²), a voltage of 1 to 100 V (preferably 5 to 50 V), an electrolysis time of 1 to 100 seconds (preferably 5 to 60 seconds), and a coating amount of 0.1 to 5 g/m² (preferably 0.2 to 3 g/m²).

As an electrolytic bath used in the underlayer anodization treatment step, an aqueous solution containing sulfuric acid or phosphoric acid is preferable, and an aqueous solution containing sulfuric acid is more preferable.

### (Third anodization treatment step)

In the manufacturing method of a support, a step (third anodization treatment step) of performing an anodization treatment with a phosphoric acid solution after the above-described first anodization treatment and pore widening treatment and before the above-described second anodization treatment to form an anodic oxide film having a larger pore diameter may be performed.

A procedure of the anodization treatment step is not particularly limited, and examples thereof include known methods.

In the third anodization treatment step, a phosphoric acid aqueous solution can be used as the electrolytic bath. For example, a concentration of phosphoric acid in the phosphoric acid aqueous solution is 10 to 300 g/L.

Conditions for the anodization treatment are appropriately set depending on the electrolytic solution, and examples thereof include a solution temperature of 5°C to 70°C (preferably 10°C to 60°C), a current density of 0.5 to 60 A/dm² (preferably 5 to 60 A/dm²), a voltage of 1 to 100 V (preferably 5 to 50 V), an electrolysis time of 1 to 100 seconds (preferably 5 to 60 seconds), and a coating amount of 0.1 to 5 g/m² (preferably 0.2 to 3 g/m²).

As the electrolytic bath used in the third anodization treatment, an aqueous solution containing phosphoric acid is preferable.

### (Silicate treatment step)

The manufacturing method of a support preferably includes a silicate treatment step of performing a silicate treatment on the aluminum plate on which the anodic oxide film is formed by the treatment such as the anodization treatment and the pore widening treatment. This is because a support having a specific Si atomic weight within a predetermined range can be easily manufactured by the silicate treatment step.

The silicate treatment is a treatment of bringing an aqueous solution containing an alkali metal silicate such as sodium silicate and potassium silicate (hereinafter, also referred to as "treatment liquid") into contact with the anodic oxide film formed on the aluminum plate. In the silicate treatment, it is preferable to immerse the aluminum plate having the anodic oxide film in the treatment liquid.

For the silicate treatment, the methods and procedures described in US2714066B and US3181461B can be referred to, and the descriptions thereof are incorporated in the present specification.

Examples of the alkali metal silicate used in the silicate treatment include sodium silicate, potassium silicate, and lithium silicate. The treatment liquid may further contain an appropriate amount of a hydroxide of an alkali metal such as sodium hydroxide, potassium hydroxide, and lithium hydroxide, in addition to the alkali metal silicate.

In addition, the treatment liquid may further contain an alkaline earth metal salt or a Group 4 (Group IVA) metal salt. Examples of the alkaline earth metal salt include nitrates such as calcium nitrate, strontium nitrate, magnesium nitrate, and barium nitrate; sulfates; hydrochlorides; phosphates; acetates; oxalates; and borates. Examples of the Group 4 (Group IVA) metal salt include titanium tetrachloride, titanium trichloride, potassium titanium fluoride, potassium titanium oxalate, titanium sulfate, titanium tetraiodide, zirconium oxychloride, zirconium dioxide, zirconium oxychloride, and zirconium tetrachloride. These alkaline earth metal salts and Group 4 (Group IVA) metal salts are used alone or in combination of two or more kinds thereof.

The treatment conditions of the silicate treatment, the concentration of the treatment liquid, and the like are appropriately adjusted depending on the size of the aluminum plate and the anodic oxide film to be treated, the structure (specific structure) and density of the micropores, and the like.

The content of the alkali metal silicate in the treatment liquid is, for example, 3% to 30% by mass, preferably 3% to 10% by mass with respect to the total mass of the treatment liquid.

The temperature of the treatment liquid in a case of being used in the silicate treatment is, for example, 30°C to 80°C, and more preferably 40°C to 70°C.

The treatment time of the silicate treatment is, for example, 1 to 15 seconds, and more preferably 3 to 10 seconds.

### [Image recording layer]

The planographic printing plate precursor according to the present invention has an image recording layer.

The image recording layer is preferably an image recording layer which can be removed by at least one of printing ink or dampening water.

The image recording layer is preferably a negative tone image recording layer and more preferably a water-soluble or water-dispersible negative tone image recording layer.

Hereinafter, each component contained in the image recording layer will be described.

### <Infrared absorber>

It is preferable that the image recording layer contain an infrared absorber.

The infrared absorber is not particularly limited, and examples thereof include pigments and dyes.

As the dye used as the infrared absorber, it is possible to use a commercially available dye and a known dye described in publications of "Dye Handbooks" (edited by the Society of Synthetic Organic Chemistry, Japan, published in 1970) and the like. Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, a cyanine coloring agent, a squarylium coloring agent, a pyrylium salt, a nickel thiolate complex, or an indolenine cyanine coloring agent is preferable, a cyanine coloring agent or an indolenine cyanine coloring agent are more preferable, and a cyanine coloring agent is still more preferable.

In addition, the infrared absorber is preferably a cationic polymethine coloring agent having an oxygen atom or a nitrogen atom at a meso-position. Preferred examples of the cationic polymethine coloring agent include a cyanine coloring agent, a pyrylium coloring agent, a thiopyrylium coloring agent, and an azulenium coloring agent; and from the viewpoint of ease of availability, solubility in a solvent during an introduction reaction, and the like, a cyanine coloring agent is preferable.

Specific examples of the cyanine coloring agent include compounds described in paragraphs 0017 to 0019 of JP2001-133969A, compounds described in paragraphs 0016 to 0021 of JP2002-023360A, compounds described in paragraphs 0012 to 0037 of JP2002-040638A, compounds described in paragraphs 0034 to 0041 of JP2002-278057A, compounds described in paragraphs 0080 to 0086 of JP2008-195018A, compounds described in paragraphs 0035 to 0043 of JP2007-090850A, and compounds described in paragraphs 0105 to 0113 of JP2012-206495A.

In addition, compounds described in paragraphs 0008 and 0009 of JP1993-005005A (JP-H5-005005A) and paragraphs 0022 to 0025 of JP2001-222101A can be also preferably used.

As the pigment, a compound described in paragraphs 0072 to 0076 of JP2008-195018A is preferable.

The infrared absorber preferably includes an infrared absorber that decomposes due to infrared exposure (decomposition-type infrared absorber), and more preferably includes a decomposition and color-forming type infrared absorber.

It is presumed that, by using a decomposition-type infrared absorber as the infrared absorber, polymerization is promoted by the decomposition-type infrared absorber or a decomposition product thereof, and a decomposition product of the decomposition-type infrared absorber and the polymerizable compound interact with each other, thereby improving the printing durability.

The decomposition-type infrared absorber preferably has a substituent that is cleaved by infrared or heat. The substituent that is cleaved by infrared exposure or heat is a substituent having a bond that is cleaved by any of energy generated in a case where an excited state generated by absorption of infrared is returned to a ground state, a chemical reaction proceeding from the excited state, or heat generated due to infrared.

In addition, it is preferable that the decomposition-type infrared absorber preferably has a function of absorbing infrared rays upon exposure to infrared rays and converting the absorbed infrared rays into heat.

It is sufficient that the decomposition-type infrared absorber absorbs at least a part of light in an infrared wavelength range (wavelength of 750 nm to 1 mm) to be decomposed; and an infrared absorber having a maximal absorption wavelength in a wavelength range of 750 to 1,400 nm is preferable, and an infrared absorber having a maximal absorption wavelength in a wavelength range of 760 to 900 nm is more preferable.

In addition, the decomposition-type infrared absorber is preferably a compound which is decomposed due to exposure to infrared rays to generate a compound having a maximal absorption wavelength in a wavelength range of 500 to 600 nm.

As the decomposition-type infrared absorber, an infrared absorber which is decomposed by heat, electron migration, or both due to exposure to infrared rays is preferable, and an infrared absorber which is decomposed by electron migration due to exposure to infrared rays is more preferable. "Decomposes by electron migration" mentioned herein means that electrons excited to the lowest unoccupied molecular orbital (LUMO) from the highest occupied molecular orbital (HOMO) of the decomposition-type infrared absorber by exposure to infrared move to electron accepting groups (groups having potential close to LUMO) in a molecule by means of intramolecular electron migration and thus result in decomposition.

Specific preferred examples of the infrared absorber (particularly, the infrared absorber that decomposes by infrared exposure) include compounds described in WO2020/262692A, JP2008-544322A, WO2016/027886A, and WO2019/219560A, the descriptions of which are incorporated herein by reference.

Examples of the substituent that is cleaved by infrared or heat, which is contained in the decomposition-type infrared absorber, include groups represented by -O-R¹, -NR^{a}R^{b}, -NR^{c}(SO₂R^{d}), and -NR^{e}(CO₂R^{f}).

Here, R¹ represents a substituent in which an R¹-O bond is cleaved by heat or infrared exposure, R^{a} and R^{b} each independently represent an aryl group, R^{c}, R^{e}, and R^{f} each independently represent an alkyl group or an aryl group, R^{d} represents an alkyl group, an aryl group, or -NR^{d1}R^{d2}, and R^{d1} and R^{d2} each independently represent a hydrogen atom, an alkyl group, or an aryl group.

Preferred aspects of the groups represented by -O-R¹, -NR^{a}R^{b}, -NR^{c}(SO₂R^{d}), and -NR^{e}(CO₂R^{f}) described above will be described later.

From the viewpoint of on-press developability and chemical resistance, the decomposition-type infrared absorber is more preferably a compound represented by Formula (A).

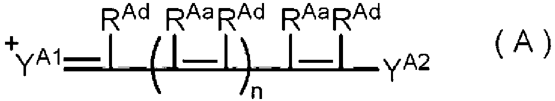

In Formula A, ⁺Y^{A1}= is the following structure: 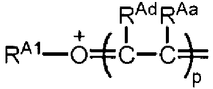 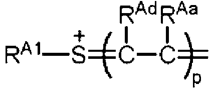 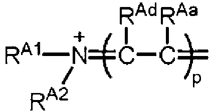
is represented by one
   YA² is the following structure: 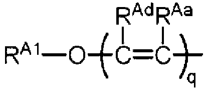 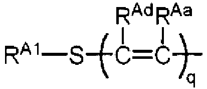 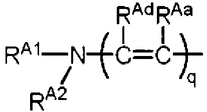
is represented by one, n represents 0, 1, 2, or 3, p and q each independently represent 0, 1, or 2, R^{A1} and R^{A2} each independently represent a hydrocarbon group, or two of R^{A1}, R^{A2}, R^{Ad}, and R^{Aa} include atoms necessary to form a cyclic structure together, at least one of R^{Ad}'s represents a group which is converted into a group that is a stronger electron donor than R^{Ad} by a chemical reaction induced by exposure to infrared irradiation or heat, or at least one of R^{Aa}'s represents a group which is converted into a group that is a stronger electron donor than R^{Aa} by a chemical reaction induced by exposure to infrared irradiation or heat, and other R^{Ad}'s and R^{Aa}'s each independently represent a group selected from the group consisting of a hydrogen atom, a halogen atom, -R^{Ae}, -OR^{Af}, -SR^{Ag}, and -NR^{Au}R^{Av}, where R^{Ae}, R^{Af}, R^{Ag}, R^{Au}, and R^{Av} each independently represent an aliphatic hydrocarbon group, an aryl group, or a heteroaryl group, and the conversion is a conversion which provides an increase in light absorption at a wavelength of 400 nm to 700 nm.

In addition, the hydrocarbon group in R^{A1} and R^{A2}, and the aliphatic hydrocarbon group, the aryl group, or the heteroaryl group in R^{Ae}, R^{Af}, R^{Ag}, R^{Au}, and R^{Av} may have a substituent.

In addition, it is preferable that the above-described R^{Ad} to be converted by a chemical reaction is any of the following groups.

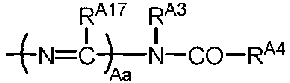

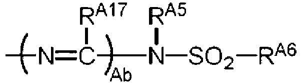

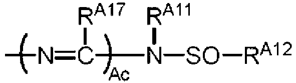

-SO₂-NR^{A15}R^{A16}

-S-L^{A}-CR^{A7}(H)_{1-Ad}(R^{A8})_{Ad}-NR^{A9}-COOR^{A18}

In the formula, Aa, Ab, Ac, and Ad each independently represent 0 or 1, -L^{A}-represents a bonding group, R^{A17} represents a hydrogen atom, an aliphatic hydrocarbon group which may be substituted or an aryl group which may be substituted, or a heteroaryl group which may be substituted, or R^{A17} and R^{A3}, R^{A17} and R^{A5}, or R^{A17} and R^{A11} include atoms necessary to form a ring structure together, R^{A4} is -OR^{A10}, -NR^{A13}R^{A14}, or -CF₃, R^{A10} represents an aryl group which may be substituted, a heteroaryl group which may be substituted, or an α-branched aliphatic hydrocarbon group, R^{A13} and R^{A14} each independently represent a hydrogen atom, an aliphatic hydrocarbon group which may be substituted, an aryl group which may be substituted, or a heteroaryl group which may be substituted, or R^{A13} and R^{A14} include atoms necessary to form a ring structure together, R^{A3} is a hydrogen atom, an aliphatic hydrocarbon group which may be substituted, an aryl group which may be substituted, or a heteroaryl group which may be substituted, or R^{A3} includes atoms necessary to form a ring structure together with at least one of R^{A10}, R^{A13}, or R^{A14}, R^{A6} represents an aliphatic hydrocarbon group which may be substituted, an aryl group which may be substituted, a heteroaryl group which may be substituted, -OR^{A10}, -NR^{A13}R^{A14}, or -CF₃, where R^{A10}, R^{A13}, and R^{A14} have the same meanings as those in R^{A4}, R^{A5} represents a hydrogen atom, an aliphatic hydrocarbon group which may be substituted, an aryl group which may be substituted, or a heteroaryl group which may be substituted, or R^{A5} includes atoms necessary to form a ring structure together with at least one of R^{A10}, R^{A13}, or R^{A14}, R^{A11}, R^{A15}, and R^{A16} each independently represent a hydrogen atom, an aliphatic hydrocarbon group which may be substituted, an aryl group which may be substituted, or a heteroaryl group which may be substituted, or R^{A15} and R^{A16} include atoms necessary to form a ring structure together, R^{A12} represents an aliphatic hydrocarbon group which may be substituted, an aryl group which may be substituted, or a heteroaryl group which may be substituted, R^{A7} and R^{A9} each independently represent a hydrogen atom or an aliphatic hydrocarbon group which may be substituted, R^{A8} represents -COO- or -COOR^{A8'}, where R^{A8'} represents a hydrogen atom, an alkali metal cation, an ammonium ion, or a mono-, di-, tri-, or tetraalkylammonium ion, and R^{A18} represents an aryl group which may be substituted, a heteroaryl group which may be substituted, or an α-branched aliphatic hydrocarbon group.

From the viewpoint of on-press developability and chemical resistance, the compound having a substituent which is cleaved by heat or infrared exposure is particularly preferably a compound represented by Formula (1).

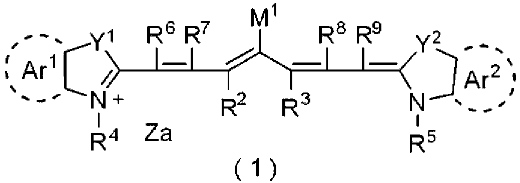

In Formula (1), M¹ is a substituent which is cleaved by heat or infrared exposure, R² and R³ each independently represent a hydrogen atom or an alkyl group, R² and R³ may be linked to each other to form a ring, Ar¹ and Ar² each independently represent a group which forms a benzene ring or a naphthalene ring, Y¹ and Y² each independently represent an oxygen atom, a sulfur atom, -NR⁰-, or a dialkylmethylene group, R⁴ and R⁵ each independently represent an aliphatic hydrocarbon group, R⁶ to R⁹ each independently represent a hydrogen atom or an alkyl group, R⁰ represents a hydrogen atom, an alkyl group, or an aryl group, and Za represents a counterion which neutralizes a charge.

The compound represented by Formula (1) is preferably a compound which decomposes upon exposure to heat or infrared to generate a compound having a maximal absorption wavelength of 500 nm to 600 nm.

Preferred aspects of M¹ in Formula (1) will be described later.

In addition, R² to R⁹, R⁰, Ar¹, and Ar² may have a substituent such as a hydrophilic group described later. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, a phosphonic acid group, a phosphonate group, and a group obtained by combining these groups. In addition, in a case where the above-described group is an anionic group, a salt may be formed, and the counter cation may be a cation of a cyanine dye structure, a proton, a metal cation, an onium, or the like.

The alkyl group as R² to R⁹ and R⁰ in Formula (1) is preferably an alkyl group having 1 to 30 carbon atoms, more preferably an alkyl group having 1 to 15 carbon atoms, and still more preferably an alkyl group having 1 to 10 carbon atoms. The above-described alkyl group may be linear or branched, or may have a ring structure.

Among these alkyl groups, a methyl group, an ethyl group, a propyl group, or a butyl group is preferable.

The aryl group represented by R⁰ is preferably an aryl group having 6 to 30 carbon atoms, more preferably an aryl group having 6 to 20 carbon atoms, and even more preferably an aryl group having 6 to 12 carbon atoms.

The aryl group may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

Specific examples thereof include a phenyl group, a p-methoxyphenyl group, a p-dimethylaminophenyl group, and a naphthyl group.

It is preferable that R² and R³ be linked to each other to form a ring.

In a case where R² and R³ are linked to each other to form a ring, the ring is preferably a 5- or 6-membered ring and more preferably a 6-membered ring.

Y¹ and Y² each independently represent an oxygen atom, a sulfur atom, -NR⁰-, or a dialkylmethylene group, preferably -NR⁰- or a dialkylmethylene group, and more preferably a dialkylmethylene group.

R₀ represents a hydrogen atom, an alkyl group, or an aryl group. R₀ is preferably an alkyl group.

It is preferred that both R⁴ and R⁵ represent the same group. In addition, in a case where R⁴ and R⁵ have an anionic group, it is preferable that R⁴ and R⁵ are the same group except that R⁴ and R⁵ have an anionic group and have or do not have a counter cation.

R⁴ and R⁵ preferably each independently represent a linear alkyl group or an alkyl group having a sulfonate group on a terminal, and more preferably each independently represent a methyl group, an ethyl group, or a butyl group having a sulfonate group on a terminal.

In addition, the counter cation of the sulfonate group may be a quaternary ammonium group in Formula (1), or may be an alkali metal cation or an alkaline earth metal cation.

R⁶ and R⁹ each independently represent a hydrogen atom or an alkyl group, and preferably each independently represent a hydrogen atom.

Ar¹ and Ar² each independently represent a group forming a benzene ring or a naphthalene ring. The benzene ring and the naphthalene ring may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

Za represents a counterion that neutralizes a charge, and examples of the counterion in a case of indicating an anion species include a sulfonate ion, a carboxylate ion, a tetrafluoroborate ion, a hexafluorophosphate ion, a p-toluenesulfonate ion, and a perchlorate ion, and a hexafluorophosphate ion is particularly preferable. In a case of indicating a cationic species, examples thereof include an alkali metal ion, an alkaline earth metal ion, an ammonium ion, a pyridinium ion, and a sulfonium ion. Among these, a sodium ion, a potassium ion, an ammonium ion, a pyridinium ion, or a sulfonium ion is preferable, and a sodium ion, a potassium ion, or an ammonium ion is more preferable.
R¹ to R⁹, R⁰, Ar¹, Ar², Y¹, and Y² may have an anion structure or a cation structure, and in a case where all R¹ to R⁹, R⁰, Ar¹, Ar², Y¹, and Y² represent a charge-neutral group, Za represents a monovalent counter anion. However, for example, in a case where R¹ to R⁹, R⁰, Ar¹, Ar², Y¹, and Y² have two or more anion structures, Za may represent a counter cation.

From the viewpoint of edge stain suppressing property, color developability, and color developability over time, M¹ in Formula (1) is preferably -NR^{a}R^{b}, -NR^{c}(SO₂R^{d}), or -NR^{e}(CO₂R^{f}).

Here, R^{a} and R^{b} each independently represent an aryl group, R^{c}, R^{e}, and R^{f} each independently represent an alkyl group or an aryl group, R^{d} represents an alkyl group, an aryl group, or -NR^{d1}R^{d2}, and R^{d1} and R^{d2} each independently represent a hydrogen atom, an alkyl group, or an aryl group.

The alkyl group in R^{c} to R^{f}, R^{d1}, and R^{d2} is preferably an alkyl group having 1 to 20 carbon atoms.

In addition, the aryl group in R^{a} to R^{f}, R^{d1}, and R^{d2} is preferably an aryl group having 6 to 20 carbon atoms.

The alkyl group and the aryl group in R^{a} to R^{f}, R^{d1}, and R^{d2} may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, a phosphonic acid group, a phosphonate group, and a group obtained by combining these groups. In addition, in a case where the above-described group is an anionic group, a salt may be formed, and the counter cation may be a cation of a cyanine dye structure, a proton, a metal cation, an onium, or the like.

In addition, M¹ in Formula (1) is preferably -O-R¹.

Here, R¹ represents a substituent in which an R¹-O bond is cleaved by heat or infrared exposure.

From the viewpoint of color developability, R¹ is preferably a group represented by any of Formulae 1-1 to 1-7, and more preferably a group represented by any of Formulae 1-1 to 1-3.

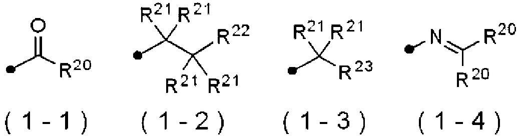

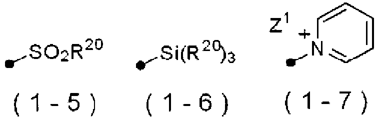

In Formulae 1-1 to 1-7, • represents a bonding site to an oxygen atom, R²⁰'s each independently represent a hydrogen atom, an alkyl group, an alkenyl group, an aryl group, -OR²⁴, -NR²⁵R²⁶, or -SR²⁷, R²¹'s each independently represent a hydrogen atom, an alkyl group, or an aryl group, R²² represents an aryl group, -OR²⁴, -NR²⁵R²⁶, -SR²⁷, -C(=O)R²⁸, -OC(=O)R²⁸, or a halogen atom, R²³ represents an aryl group, an alkenyl group, an alkoxy group, or an onium group, R²⁴ to R²⁷ each independently represent a hydrogen atom, an alkyl group, or an aryl group, R²⁸'s each independently represent an alkyl group, an aryl group, -OR²⁴, -NR²⁵R²⁶, or -SR²⁷, and Z¹ represents a counterion that neutralizes a charge.

Specific examples of the above-described compound are shown below. In the following structural formulae, Me represents a methyl group, and TsO⁻ represents a tosylate anion.

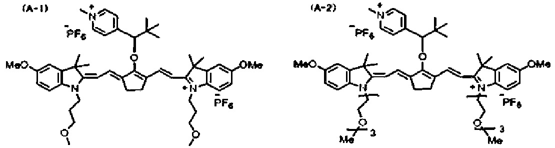

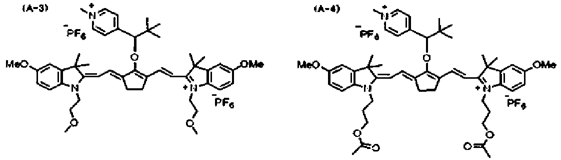

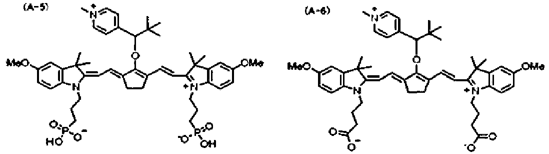

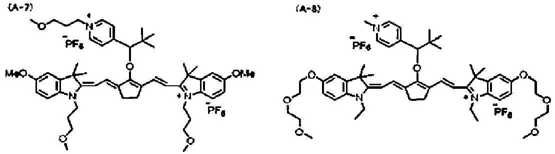

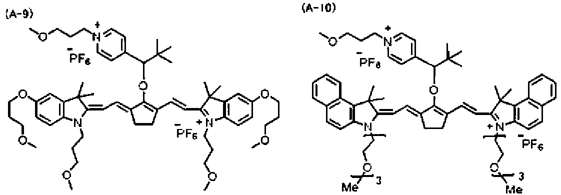

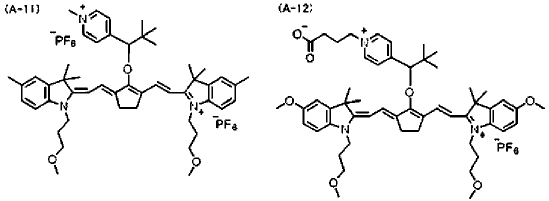

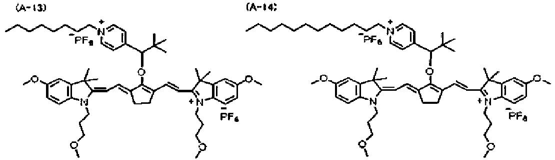

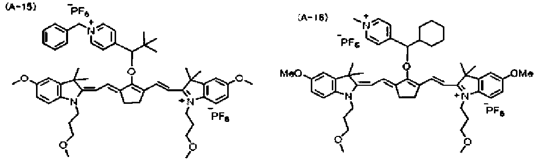

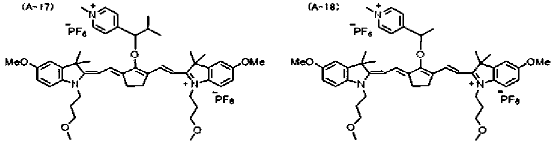

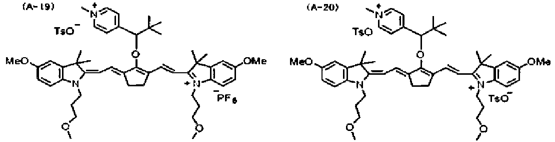

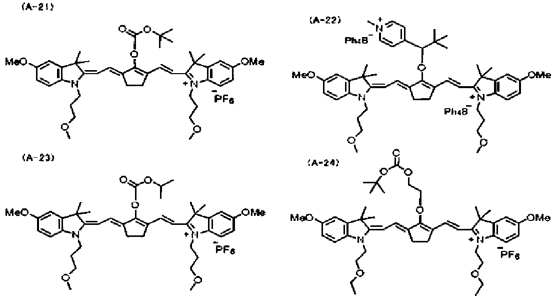

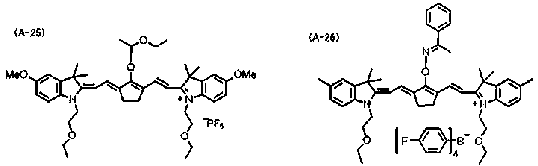

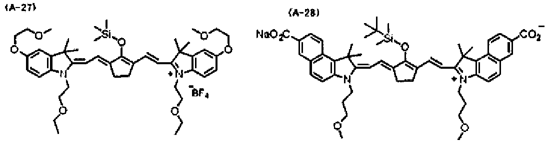

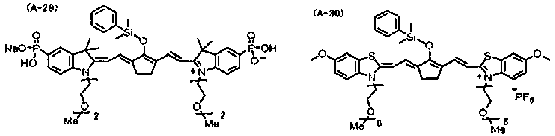

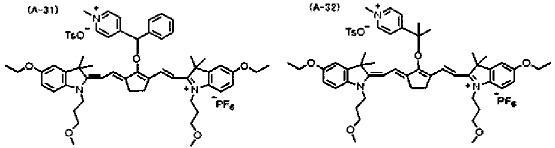

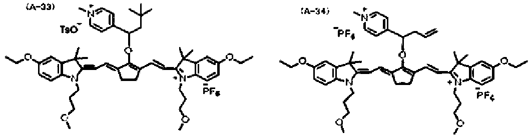

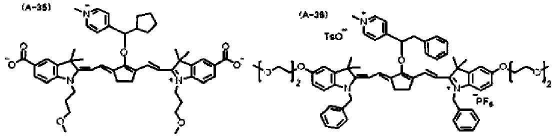

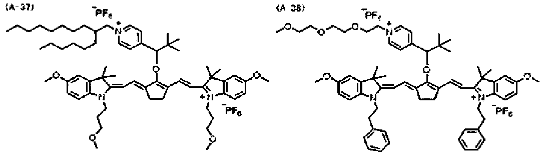

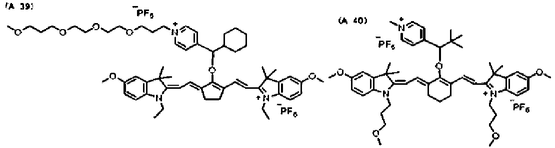

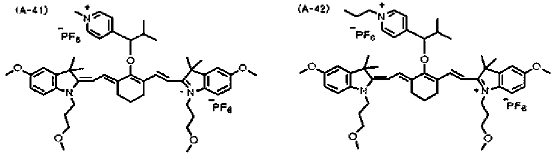

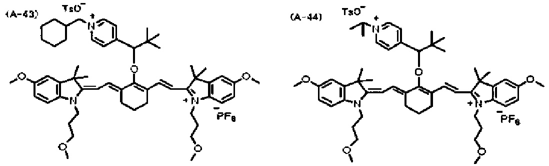

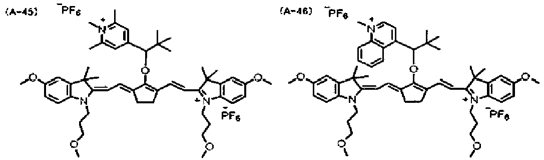

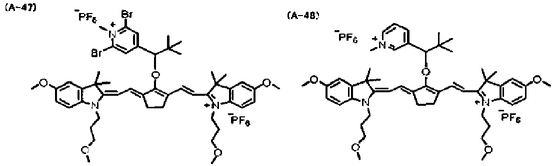

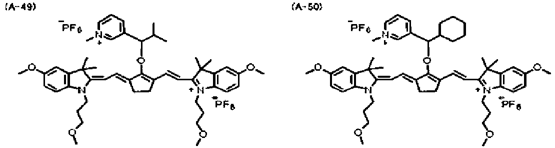

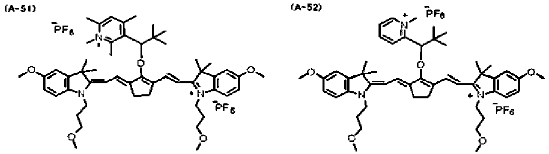

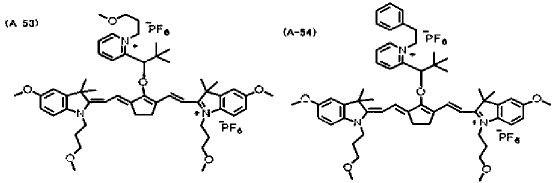

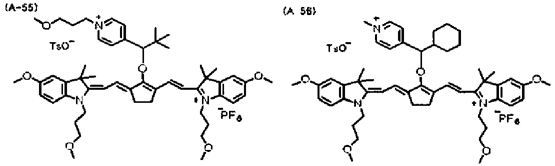

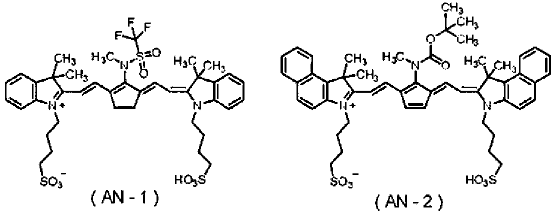

One kind of infrared absorber may be used alone, or two or more kinds of infrared absorbers may be used in combination. In addition, as the infrared absorber, the pigment and the dye may be used in combination.

A content of the infrared absorber in the image recording layer is preferably 0.1% by mass to 10.0% by mass and more preferably 0.5% by mass to 5.0% by mass with respect to the total mass of the image recording layer.

### <Acid color former>

The image recording layer contains an acid color-forming agent.

In the present specification, the "acid color-forming agent" means a compound which forms color by an electron-accepting compound such as an acid and has a property of changing the color of the image recording layer.

The acid color-forming agent is preferably a compound which forms color by being heated in a state of receiving an electron-accepting compound such as an acid.

Examples of the above-described acid include a protonic acid and a Lewis acid. In addition, a heating temperature during the heating is preferably 80°C to 200°C and more preferably 100°C to 180°C.

Examples of the acid color forming agent include a colorless compound having a partial skeleton such as a lactone, a lactam, a sultone, a spiropyran, an ester, and an amide, in which the partial skeleton is rapidly ring-opened or cleaved in a case of being brought into contact with an electron-accepting compound.

From the viewpoint of color formability and visibility, the acid color-forming agent preferably includes a leuco coloring agent, and it is more preferably a leuco coloring agent.

In addition, from the viewpoint of color formability and visibility, the above-described leuco coloring agent is preferably a leuco coloring agent having a phthalide structure or a fluoran structure.

From the viewpoint of developability after a lapse of time, color formability, and visibility, the acid color-forming agent is preferably a compound represented by Formula (3a) or Formula (3b), and more preferably a compound represented by Formula (3a).

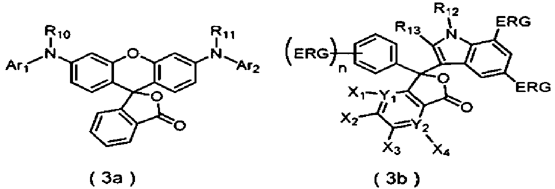

In Formula (3a), Ar₁ and Ar₂ each independently represent an aryl group which may have a substituent or a heteroaryl group which may have a substituent, and R₁₀ and R₁₁ each independently represent a hydrogen atom, an alkyl group, an aryl group which may have a substituent, or a heteroaryl group which may have a substituent.

In Formula (3b), ERG's each independently represent an electron-donating group, n represents an integer of 1 to 5, X₁ to X₄ each independently represent a hydrogen atom, a halogen atom, or a monovalent organic group, Y₁ and Y₂ each independently represent C or N, X₁ does not exist in a case where Y₁ is N, X₄ does not exist in a case where Y₂ is N, and R₁₂ and R₁₃ each independently represent a hydrogen atom, an alkyl group, an aryl group which may have a substituent, or a heteroaryl group which may have a substituent.

The alkyl group in Formula (3a) or Formula (3b) may be linear or branched, or may have a ring structure. The number of carbon atoms in the alkyl group in Formula (3a) or Formula (3b) is preferably 1 to 20, more preferably 1 to 8, still more preferably 1 to 4, and particularly preferably 1 or 2.

The number of carbon atoms in the aryl group in Formula (3a) or Formula (3b) is preferably 6 to 20, more preferably 6 to 10, and still more preferably 6 to 8. Examples of the aryl group in Formula (3a) or Formula (3b) include a phenyl group, a naphthyl group, an anthracenyl group, and a phenanthrenyl group, each of which may have a substituent.

Examples of the heteroaryl group in Formula (3a) or Formula (3b) include a furyl group, a pyridyl group, a pyrimidyl group, a pyrazoyl group, and a thiophenyl group, each of which may have a substituent.

In addition, each group such as the alkyl group, the aryl group, and the heteroaryl group in Formula (3a) or Formula (3b) may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, and a cyano group. In addition, these substituents may be further substituted with these substituents.

The above-described substituent may be an electron-donating group.

From the viewpoint of color formability and visibility, as the electron-donating group represented by ERG and the electron-donating group which is the above-described substituent, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group is preferable; an alkoxy group, an aryloxy group, a heteroaryloxy group, or an alkyl group is more preferable; and an alkoxy group is still more preferable.

From the viewpoint of color formability and visibility, R₁₀ and R₁₁ in Formula (3a) each independently preferably represent an alkyl group or an aryl group which may have an electron-donating group, more preferably represent a methyl group or an aryl group having an electron-donating group, and still more preferably represent a phenyl group having an electron-donating group at a para-position.

From the viewpoint of color formability and visibility, Ar₁ and Ar₂ in Formula (3a) each independently preferably represent an aryl group which may have at least one substituent at an ortho-position or a heteroaryl group which may have at least one substituent at an ortho-position, more preferably represent an aryl group which has at least one substituent at an ortho-position, still more preferably represent a phenyl group which has at least one substituent at an ortho-position, and particularly preferably represent a phenyl group which has at least one substituent at an ortho-position and an electron-donating group at a para-position.

From the viewpoint of color formability and visibility, R₁₂ and R₁₃ in Formula (3b) are preferably a hydrogen atom, an alkyl group, or an aryl group substituted with an alkoxy group, more preferably an alkyl group, and still more preferably a methyl group.

n in Formula (3b) is preferably an integer of 1 to 3 and more preferably 1 or 2.

From the viewpoint of color formability and visibility, X₁ to X₄ in Formula (3b) each independently preferably represent a hydrogen atom or a chlorine atom, and more preferably represent a hydrogen atom.
From the viewpoint of color formability and visibility, in Formula (3b), it is preferable that at least one of Y₁ or Y₂ is C, and it is more preferable that both Y₁ and Y₂ are C.

Preferred specific examples of the acid color-forming agent include the following compounds S-1 to S-20. Me represents a methyl group, Et represents an ethyl group, and Ph represents a phenyl group.

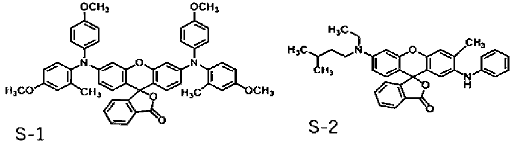

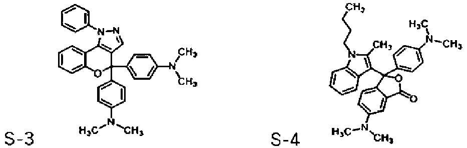

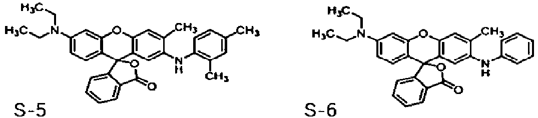

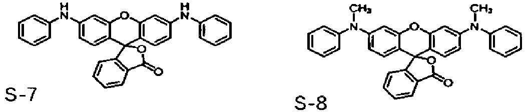

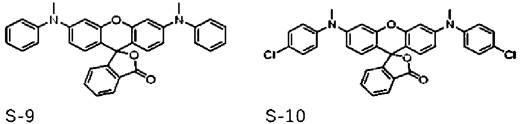

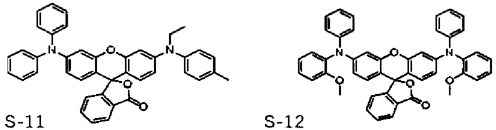

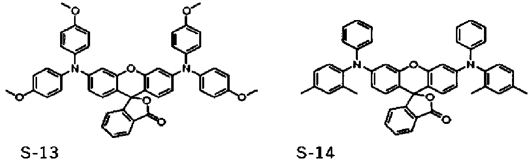

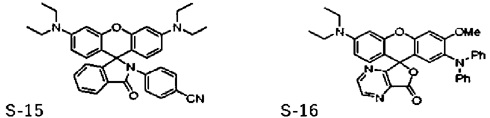

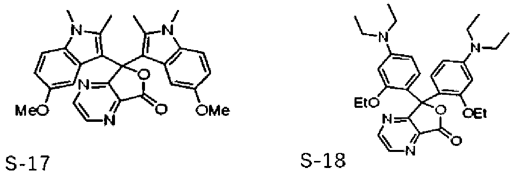

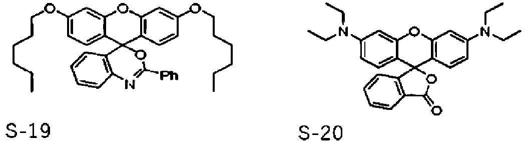

These acid color-forming agents may be used alone or in combination of two or more kinds thereof.

A content of the acid color-forming agent is preferably 0.5% to 10% by mass and more preferably 1% to 5% by mass with respect to the total mass of the image recording layer.

### <Polymerization initiator>

The image recording layer preferably contains a polymerization initiator.

The polymerization initiator is a compound which generates a polymerization initiation species such as a radical or a cation by light, heat, or energy of both light and heat. As the polymerization initiator, a compound (so-called radical polymerization initiator) which generates a radical by light, heat, or energy of both light and heat, and initiates polymerization of a compound having a polymerizable unsaturated group is preferable.

Examples of the polymerization initiator include an electron-accepting polymerization initiator and an electron-donating polymerization initiator.

The image recording layer preferably contains, as the polymerization initiator, at least one of an electron-accepting polymerization initiator or an electron-donating polymerization initiator, and more preferably contains both the electron-accepting polymerization initiator and the electron-donating polymerization initiator.

### (Electron-accepting polymerization initiator)

The electron-accepting polymerization initiator is a compound which generates a polymerization initiation species such as a radical or a cation by light, heat, or energy of both light and heat. As the electron-accepting polymerization initiator, a known thermal polymerization initiator, a compound having a bond with a small bond dissociation energy, a photopolymerization initiator, or the like can be appropriately used.

As the electron-accepting polymerization initiator, a radical polymerization initiator is preferable.

Examples of the radical polymerization initiator include (a) an organic halide, (b) a carbonyl compound, (c) an azo compound, (d) an organic peroxide, (e) a metallocene compound, (f) an azido compound, (g) a hexaarylbiimidazole compound, (i) a disulfone compound, (j) an oxime ester compound, and (k) an onium salt compound.

Examples of the (a) organic halide include compounds described in paragraphs 0022 and 0023 of JP2008-195018A.

Examples of the (b) carbonyl compound include compounds described in paragraph 0024 of JP2008-195018A.

Examples of the (c) azo compound include azo compounds described in JP1996-108621A (JP-H8-108621A).

Examples of the (d) organic peroxide include compounds described in paragraph 0025 of JP2008-195018A.

Examples of the (e) metallocene compound include compounds described in paragraph 0026 of JP2008-195018A.

Examples of the (f) azido compound include a compound such as 2,6-bis(4-azidobenzylidene)-4-methylcyclohexanone.

Examples of the (g) hexaarylbiimidazole compound include compounds described in paragraph 0027 of JP2008-195018A.

Examples of the (i) disulfone compound include compounds described in JP1986-166544A (JP-S61-166544A) and JP2002-328465A.

Examples of the (j) onium salt compound include compounds described in paragraphs 0028 to 0030 of JP2008-195018A.

As the radical polymerization initiator, an onium-based polymerization initiator is preferable. The onium-based polymerization initiator is an onium salt compound which accepts an electron by intermolecular electron migration in a case where an electron of an infrared absorber is excited by exposure to infrared rays, and generates a polymerization initiation species such as a radical.

As the onium-based polymerization initiator, from the viewpoint of more excellent printing durability, an iodonium salt compound, a sulfonium salt compound, or an azinium salt compound is preferable; an iodonium salt compound or a sulfonium salt compound is more preferable; and an iodonium salt compound is still more preferable.

As the iodonium salt compound, a diaryliodonium salt compound is preferable; a diphenyliodonium salt compound substituted with particularly an electron-donating group such as an alkyl group and an alkoxyl group is more preferable; and an asymmetric diphenyliodonium salt compound is still more preferable.

Specific examples of the iodonium salt compound include the compounds described in EP104143B, US339049A, US410201A, JP1990-150848A (JP-H2-150848A), and JP1990-296514A (JP-H2-296514A).

As a counter anion of the iodonium salt compound and the sulfonium salt compound, a sulfonamide anion or a sulfonimide anion is preferable, and a sulfonimide anion is more preferable. As the sulfonamide anion, an arylsulfonamide anion is preferable. As the sulfonimide anion, a bisarylsulfonimide anion is preferable.

Specific examples of the sulfonamide anion or the sulfonimide anion include compounds described in WO2020/262692A.

One electron-accepting polymerization initiator may be used alone, or two or more electron-accepting polymerization initiators may be used in combination.

A content of the electron-accepting polymerization initiator is preferably 0.1% to 50% by mass, more preferably 0.5% to 30% by mass, and still more preferably 0.8% to 20% by mass with respect to the total mass of the image recording layer.

### (Electron-donating polymerization initiator)

From the viewpoint of more excellent chemical resistance and printing durability of the planographic printing plate, the polymerization initiator preferably includes an electron-donating polymerization initiator.

As the electron-donating polymerization initiator, for example, the following compounds are exemplified.
(i) Alkyl or arylate complex: it is considered that a carbon-hetero bond is oxidatively cleaved, and an active radical is generated. Specific examples thereof include a borate compound.
(ii) Aminoacetic acid compound: it is considered that a C-X bond on carbon adjacent to a nitrogen is cleaved by oxidation, and an active radical is generated. As X, a hydrogen atom, a carboxy group, a trimethylsilyl group, or a benzyl group is preferable; Specific examples thereof include N-phenylglycines (which may have a substituent on the phenyl group) and N-phenyliminodiacetic acid (which may have a substituent on the phenyl group).
(iii) Sulfur-containing compound: a compound in which a nitrogen atom in the above-described aminoacetic acid compound is replaced with a sulfur atom can generate an active radical by the same action. Specific examples thereof include phenylthioacetic acid (which may have a substituent on a phenyl group).
(iv) Tin-containing compound: a compound in which a nitrogen atom in the above-described aminoacetic acid compound is replaced with a tin atom can generate an active radical by the same action.
(v) Sulfinates: an active radical can be generated by oxidation. Specific examples thereof include sodium arylsulfinate.

Specific examples of the electron-donating polymerization initiator include electron-donating polymerization initiators described in WO2020/262692A.

The image recording layer preferably contains a borate compound as the electron-donating polymerization initiator.

The borate compound is preferably a tetraaryl borate compound or a monoalkyltriaryl borate compound, from the viewpoint of compound stability, more preferably a tetraaryl borate compound, and particularly preferably a tetraphenyl borate compound.

A counter cation of the borate salt compound is not particularly limited, but an alkali metal ion or a tetraalkyl ammonium ion is preferable and a sodium ion, a potassium ion, or a tetrabutyl ammonium ion is more preferable.

As the borate salt compound, sodium tetraphenyl borate is preferable.

In a case where the image recording layer contains a borate compound as the electron-donating polymerization initiator, from the viewpoint of visibility, printing durability, and temporal stability, it is more preferable that the image recording layer further contains an onium salt compound as the electron-accepting polymerization initiator.

Examples of a preferred aspect in a case where the image recording layer contains both the electron-accepting polymerization initiator and the electron-donating polymerization initiator include an aspect in which the electron-accepting polymerization initiator and the electron-donating polymerization initiator form a salt. Examples of the salt formed of the electron-accepting polymerization initiator and the electron-donating polymerization initiator include an iodonium borate compound formed of an iodonium compound which is the onium-based polymerization initiator, and a borate compound.

Specific examples of the iodonium borate compound include compounds described in WO2020/262692A.

The electron-donating polymerization initiator may be used alone, or two or more kinds thereof may be used in combination.

A content of the electron-donating polymerization initiator (preferably, the borate compound) is preferably 0.01% to 30% by mass, more preferably 0.05% to 25% by mass, and still more preferably 0.1% to 20% by mass with respect to the total mass of the image recording layer.

A content of the polymerization initiator (total content of the electron-accepting polymerization initiator and the electron-donating polymerization initiator) is preferably 0.1% to 50% by mass, more preferably 0.5% to 30% by mass, and still more preferably 0.8% to 20% by mass with respect to the total mass of the image recording layer.

In addition, from the viewpoint of more excellent visibility, the content of the polymerization initiator (total content of the electron-accepting polymerization initiator and the electron-donating polymerization initiator) is preferably 0.5 molar equivalent or more, more preferably 1.0 molar equivalent or more, and still more preferably 3.0 molar equivalent or more with respect to the content of the acid color-forming agent. The upper limit thereof is not particularly limited, but is preferably 10.0 molar equivalent or less with respect to the content of the acid color-forming agent.

### <Polymerizable Compound>

It is preferable that the image recording layer contain a polymerizable compound.

In the present specification, the polymerizable compound refers to a compound having a polymerizable group.

The polymerizable group is not particularly limited, and may be a radically polymerizable group or a cationically polymerizable group, but a radically polymerizable group is preferable.

Examples of the radically polymerizable group include groups having an ethylenically unsaturated group such as a (meth)acryloyl group, an allyl group, a vinylphenyl group, and a vinyl group; and from the viewpoint of reactivity, a (meth)acryloyl group is preferable.

A molecular weight of the polymerizable compound (in a case of having molecular weight distribution, a weight-average molecular weight) is preferably 50 or more and less than 2,500.

The polymerizable compound may be, for example, a radical polymerizable compound or a cationically polymerizable compound, and it is preferably an addition polymerizable compound (ethylenically unsaturated compound) having at least one ethylenically unsaturated bond.

As the ethylenically unsaturated compound, a compound having at least one terminal ethylenically unsaturated bond is preferable, and a compound having two or more terminal ethylenically unsaturated bonds is more preferable. The polymerizable compound has a chemical form such as a monomer, a pre-polymer, that is, a dimer, a trimer, or an oligomer, and a mixture of these.

In particular, from the viewpoint of printing durability, the polymerizable compound preferably includes a polymerizable compound having functionalities of 3 or more, more preferably includes a polymerizable compound having functionalities of 7 or more, and still more preferably includes a polymerizable compound having functionalities of 10 or more. In addition, from the viewpoint of printing durability of the planographic printing plate to be obtained, the above-described polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).

From the viewpoint of on-press developability and inhibition property of color fading failure over time, the image recording layer preferably includes a polymerizable compound having functionalities of 2 or less, more preferably includes a difunctional polymerizable compound, and still more preferably includes a difunctional (meth)acrylate compound.

From the viewpoint of printing durability, on-press developability, and suppressing property of the color-forming defect over time, a content of the polymerizable compound having functionalities of 2 or less (preferably a bifunctional polymerizable compound) is preferably 5% to 100% by mass, more preferably 10% to 100% by mass, and still more preferably 15% to 100% by mass with respect to the total mass of the polymerizable compound in the above-described image recording layer.

### (Oligomer)

As the polymerizable compound contained in the image recording layer, a polymerizable compound as an oligomer is preferable.

In the present specification, the oligomer represents a polymerizable compound having a molecular weight (in a case of having molecular weight distribution, a weight-average molecular weight) of 600 to 40,000 and at least one polymerizable group.

Hereinafter, the polymerizable compound as an oligomer, contained in the image recording layer, is also simply referred to as "oligomer".

From the viewpoint of excellent chemical resistance and printing durability, the molecular weight of the oligomer is preferably 1,000 to 25,000.

In addition, from the viewpoint of improving printing durability, the number of polymerizable groups in one molecule of the oligomer is preferably 2 or more, more preferably 3 or more, still more preferably 6 or more, and particularly preferably 10 or more.

In addition, the upper limit value of the polymerizable groups in the oligomer is not particularly limited, but the number of polymerizable groups is preferably 20 or less.

From the viewpoint of printing durability and on-press developability, the oligomer is preferably a polymerizable compound having 7 or more polymerizable groups and having a molecular weight of 1,000 to 40,000, and more preferably a polymerizable compound having 7 to 20 polymerizable groups and having a molecular weight of 1,000 to 25,000.

The image recording layer may contain a polymer component which is likely to be generated in the process of manufacturing the oligomer.

From the viewpoint of printing durability, visibility, and on-press developability, the oligomer preferably includes at least one selected from the group consisting of a compound having a urethane bond, a compound having an ester bond, and a compound having an epoxy residue, and preferably includes a compound having a urethane bond.

In the present specification, the epoxy residue refers to a structure formed of an epoxy group, and for example, the epoxy residue means a structure similar to a structure obtained by a reaction between an acid group (carboxylic acid group or the like) and an epoxy group.

As the compound having a urethane bond, compounds described in WO2020/262692A can be suitably used.

As the compound having a urethane bond, a compound may also be used which is prepared by obtaining polyurethane by a reaction between a polyisocyanate compound and a polyol compound and introducing a polymerizable group into the polyurethane by a polymer reaction.

For example, the compound having a urethane bond may be obtained by reacting a polyol compound having an acid group with a polyisocyanate compound to obtain a polyurethane oligomer and reacting the obtained polyurethane oligomer with a compound having an epoxy group and a polymerizable group.

The number of polymerizable groups in the compound having an ester bond, which is an example of the oligomer, is preferably 3 or more, and more preferably 6 or more. The upper limit value thereof is preferably 20 or less.

As the compound having an epoxy residue, which is an example of the oligomer, a compound containing a hydroxy group in the compound is preferable.

In addition, the number of polymerizable groups in the compound having an epoxy residue is preferably 2 to 6 and more preferably 2 or 3.

The above-described compound having an epoxy residue can be obtained, for example, by reacting a compound having an epoxy group with an acrylic acid.

As the oligomer, a commercially available product may also be used, and examples thereof include UA510H, UA-306H, UA-306I, and UA-306T (all manufactured by KYOEISHA CHEMICAL Co., Ltd.), UV-1700B, UV-6300B, and UV7620EA (all manufactured by The Nippon Synthetic Chemical Industry Co., Ltd.), U-15HA (manufactured by SHIN-NAKAMURA CHEMICAL Co., Ltd.), and EBECRYL450, EBECRYL657, EBECRYL885, EBECRYL800, EBECRYL3416, and EBECRYL860 (all manufactured by DAICEL-ALLNEX LTD.); but the oligomer is not limited to these.

From the viewpoint of improving chemical resistance, printing durability, and suppressing property of on-press developing residues, a content of the oligomer is preferably 30% to 100% by mass, more preferably 50% to 100% by mass, and still more preferably 80% to 100% by mass with respect to the total mass of the polymerizable compound in the image recording layer.

### (Low-molecular-weight polymerizable compound)

The polymerizable compound may further include a polymerizable compound other than the above-described oligomer.

From the viewpoint of chemical resistance, a low-molecular-weight polymerizable compound is preferable as the polymerizable compound other than the oligomer. The low-molecular-weight polymerizable compound may have a chemical form such as a monomer, a dimer, a trimer, and a mixture of these.

In addition, from the viewpoint of chemical resistance, the low-molecular-weight polymerizable compound is preferably at least one polymerizable compound selected from the group consisting of a polymerizable compound having three or more ethylenically unsaturated groups and a polymerizable compound having an isocyanuric ring structure.

In the present specification, the low-molecular-weight polymerizable compound refers to a polymerizable compound having a molecular weight (in a case of having molecular weight distribution, a weight-average molecular weight) of 50 or more and less than 600.

From the viewpoint of excellent chemical resistance, printing durability, and suppressing property of on-press developing residues, the molecular weight of the low-molecular-weight polymerizable compound is preferably 100 or more and less than 600, more preferably 300 or more and less than 600, and still more preferably 400 or more and less than 600.

In a case where the polymerizable compound includes the low-molecular-weight polymerizable compound as the polymerizable compound other than the oligomer (in a case where the polymerizable compound includes two or more kinds of low-molecular-weight polymerizable compounds, the total amount thereof), from the viewpoint of chemical resistance, printing durability, and suppressing property of on-press developing residues, a ratio of the above-described oligomer to the low-molecular-weight polymerizable compound (oligomer/low-molecular-weight polymerizable compound) is preferably 10/1 to 1/10, more preferably 10/1 to 3/7, and still more preferably 10/1 to 7/3 based on mass.

As the low-molecular-weight polymerizable compound, polymerizable compounds described in paragraphs 0082 to 0086 of WO2019/013268A can also be suitably used.

Details of the method of use, such as the structure of the polymerizable compound, whether the polymerizable compound is used alone or in combination, and the addition amount, can be set optionally.

Particularly, from the viewpoint of printing durability, the image recording layer preferably contains two or more polymerizable compounds.

A content of the polymerizable compound (in a case where the image recording layer contains two or more polymerizable compounds, the total content of the polymerizable compounds) is preferably 5% to 75% by mass, more preferably 10% to 70% by mass, and still more preferably 15% to 60% by mass with respect to the total mass of the image recording layer.

### <Particle>

From the viewpoint of printing durability, it is preferable that the image recording layer contain particles.

The particles may be any of organic particles or inorganic particles, but from the viewpoint of printing durability, organic particles are preferable, and polymer particles are more preferable.

The organic particles mean particles composed of an organic substance, and the polymer particles mean particles composed of a polymer. In other words, the polymer particles mean a polymer having a particle shape among polymers contained in the image recording layer.

It is preferable that the polymer particles are particles selected from the group consisting of thermoplastic resin particles, thermally reactive resin particles, polymer particles having a polymerizable group, microcapsules encapsulating a hydrophobic compound, and microgels (cross-linked polymer particles). Among these, polymer particles having a polymerizable group or microgels are preferable.

The polymer particles preferably contain at least one ethylenically unsaturated group because an effect of improving the printing durability of the exposed portion and the on-press developability of the non-exposed portion can be obtained.

In addition, from the viewpoint of printing durability and on-press developability, thermoplastic resin particles are preferable as the polymer particles.

Specific examples of the above-described polymer particles that may be contained in the image recording layer include the polymer particles described in WO2020/262692A, the description of which is incorporated herein by reference.

As inorganic particles, known inorganic particles can be used, and metal oxide particles such as silica particles and titania particles can be suitably used.

An average particle diameter of the above-described particles is preferably 0.01 to 3.0 µm, more preferably 0.03 to 2.0 µm, and still more preferably 0.10 to 1.0 µm. In a case where the average particle diameter is in this range, excellent resolution and excellent temporal stability are obtained.

The average particle diameter of the particles is measured by a dynamic light scattering method, as in the average particle diameter of the thermoplastic resin particles described above. Instead of the measurement by the dynamic light scattering method, a transmission electron micrograph of the particles may be imaged, particle diameters of a total of 5,000 particles may be measured on the micrograph, and an arithmetic average value may be calculated and used as the average particle diameter of the particles. Non-spherical particles are defined as having a diameter of a circle having the same area as the particle area in the photograph.

In addition, the average particle diameter of the particles is a volume average particle size unless otherwise specified.

The image recording layer may contain only one kind of the particles (preferably the polymer particles) or may contain two or more kinds thereof.

From the viewpoint of on-press developability and printing durability, a content of the particles (preferably, the polymer particles) in the above-described image recording layer is preferably 5% to 90% by mass, more preferably 10% to 90% by mass, still more preferably 20% to 90% by mass, and particularly preferably 50% to 90% by mass with respect to the total mass of the above-described image recording layer.

### <Binder polymer>

The image recording layer may contain a binder polymer.

The polymer particles do not correspond to the binder polymer. That is, the binder polymer is a polymer that is not in the form of particles.

As the binder polymer, a (meth)acrylic resin, a polyvinyl acetal resin, or a polyurethane resin is preferable.

As the binder polymer, a known binder polymer used in the image recording layer of the planographic printing plate precursor can be used, and a binder polymer used in the on-press development type planographic printing plate precursor (also referred to as a binder polymer for on-press development) can be preferably used. The binder polymer for on-press development is preferably a binder polymer having an alkylene oxide chain.

Other preferred examples of the binder polymer include a star polymer compound, a binder polymer having a constitutional unit formed of an aromatic vinyl compound, a polyvinyl acetal, and a resin having a fluorine atom (more preferably, a fluoroaliphatic group-containing copolymer). The star polymer compound is a polymer compound having a polymer chain bonded to a nucleus of a polyfunctional thiol having 6 or more and 10 or less functional groups by a sulfide bond, in which the polymer chain has a polymerizable group.

Specific examples of the binder polymer which may be contained in the image recording layer include polymers described in JP2012-148555A and WO2020/262692A, the descriptions of which are incorporated herein by reference.

The binder polymer may be used alone, or in combination of two or more kinds thereof.

The image recording layer may contain an optional amount of the binder polymer. In a case where the image recording layer contains the binder polymer, a content of the binder polymer is preferably 1% to 90% by mass and more preferably 5% to 80% by mass with respect to the total mass of the image recording layer.

### <Polymerization inhibitor>

From the viewpoint of more excellent temporal stability and developability after a lapse of time, the image recording layer preferably contains a polymerization inhibitor. In a case where the image recording layer contains a polymerization inhibitor, unnecessary thermal polymerization of the polymerizable compound, particularly the radically polymerizable compound can be prevented during the production or storage of the image recording layer.

Examples of the polymerization inhibitor include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), and an N-nitroso-N-phenylhydroxylamine aluminum salt.

As the polymerization inhibitor, a compound represented by Formula (Ph) is preferable from the viewpoint of more excellent temporal stability and developability over time.

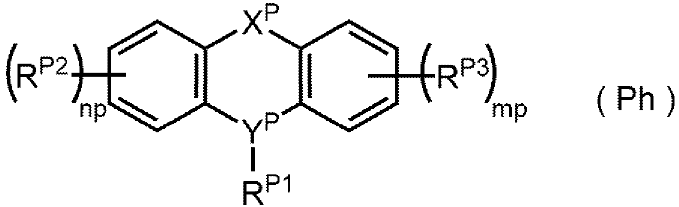

in Formula (Ph), X^{P} represents O, S, or NH, Y^{P} represents N or CH, R^{P1} represents a hydrogen atom or an alkyl group, R^{P2} and R^{P3} each independently represent a halogen atom, an alkylthio group, an arylthio group, an alkoxy group, an aryloxy group, an alkyl group, an aryl group, an acylthio group, or an acyl group, and mp and np each independently represent an integer of 0 to 4.

From the viewpoint of temporal stability and developability after a lapse of time, X^{P} in Formula (Ph) is preferably O or S and more preferably S.

From the viewpoint of temporal stability and developability after a lapse of time, Y^{P} in Formula (Ph) is preferably N.

From the viewpoint of temporal stability and developability after a lapse of time, R^{P1} in Formula (Ph) is preferably a hydrogen atom or a methyl group and more preferably a hydrogen atom.

R^{P2} and R^{P3} in Formula (Ph) each independently are preferably a halogen atom, an alkylthio group, an arylthio group, an alkoxy group, an aryloxy group, an alkyl group, or an aryl group.

From the viewpoint of temporal stability and developability after a lapse of time, mp and np in Formula (Ph) are each independently preferably an integer of 0 to 2, more preferably 0 or 1, and still more preferably 0.

The polymerization inhibitor may be used alone, or in combination of two or more kinds thereof.

A content of the polymerization inhibitor is preferably 0.001% to 5% by mass and more preferably 0.01% to 1% by mass with respect to the total mass of the image recording layer.

### <Chain Transfer Agent>

The image recording layer may contain a chain transfer agent. The chain transfer agent contributes to improvement of printing durability of the planographic printing plate.

The chain transfer agent is preferably a thiol compound, and from the viewpoint of boiling point (difficulty of being volatilized), it is more preferably a thiol compound having 7 or more carbon atoms and still more preferably a compound (aromatic thiol compound) having 7 or more carbon atoms and having a mercapto group on an aromatic ring. The above-described thiol compound is preferably a monofunctional thiol compound.

Specific examples of the chain transfer agent include compounds described in WO2020/262692A.

The chain transfer agent may be used alone, or in combination of two or more kinds thereof.

A content of the chain transfer agent is preferably 0.01% to 50% by mass, more preferably 0.05% to 40% by mass, and still more preferably 0.1% to 30% by mass with respect to the total mass of the image recording layer.

### <Other components>

The image recording layer may contain, as a component other than the above-described components, an oil sensitizing agent (for example, a phosphonium compound, a nitrogen-containing low-molecular-weight compound, or an ammonium group-containing polymer), a development accelerator, a surfactant, a higher fatty acid derivative, a plasticizer, an inorganic lamellar compound, or the like. For these other components, description in paragraphs 0114 to 0159 of JP2008-284817A can be referred to.

In addition, specific examples of the development accelerator include compounds described in WO2020/262692A.

### <Method of forming image recording layer>

The image recording layer can be formed, for example, by dispersing or dissolving the above-described components in a known solvent to prepare a coating liquid, coating a support with the coating liquid by a known method such as bar coating, and drying the coating liquid, as described in paragraphs 0142 and 0143 of JP2008-195018A.

As the solvent, known solvents can be used. Specific examples of the solvent include solvents described in paragraph 0142 of JP2008-195018A.

One solvent may be used alone, or two or more solvents may be used in combination. A concentration of solid contents in the coating liquid is preferably 1% to 50% by mass.

A coating amount (solid content) of the image recording layer after the coating and the drying varies depending on the applications thereof, but from the viewpoint of obtaining excellent sensitivity and excellent film-coating characteristics of the image recording layer, it is preferably 0.3 to 3.0 g/m².

A layer thickness of the image recording layer is preferably 0.1 to 3.0 µm and more preferably 0.3 to 2.0 µm.

A thickness of each layer in the planographic printing plate precursor can be measured by producing a section obtained by cutting the planographic printing plate precursor in a direction perpendicular to the surface of the planographic printing plate precursor, and observing a cross section of the section with a scanning electron microscope (SEM).

### [Other layers]

The planographic printing plate precursor may include other layers in addition to the support and the image recording layer described above.

The planographic printing plate precursor may include an undercoat layer disposed between the support and the image recording layer as necessary, for example, in order to improve adhesiveness between the support and the image recording layer.

In addition, the planographic printing plate precursor may include a protective layer (overcoat layer) on the image recording layer as necessary, in order to prevent occurrence of scratches and the like on the image recording layer, to shield oxygen, and to prevent ablation during exposure to a high-illuminance laser.

### <Undercoat layer>

The planographic printing plate precursor preferably has an undercoat layer.

In a case where the planographic printing plate precursor has an undercoat layer, for example, in a case of a negative tone image recording layer, adhesiveness between the support and the image recording layer is enhanced in an exposed portion, and the image recording layer is likely to be peeled off from the support in a non-exposed portion. Therefore, developability can be improved while a decrease in printing durability is suppressed. Furthermore, in the case of exposure to infrared laser, the undercoat layer functions as a heat insulating layer and thus brings about an effect of preventing sensitivity reduction resulting from the diffusion of heat generated by exposure to the support.

The components constituting the undercoat layer are not particularly limited, but from the viewpoint of further improving printing durability, it is preferable to include a polymer having a support absorptive group and a hydrophilic group (hereinafter, also referred to as "polymer I").

The details of the mechanism by which the printing durability of the planographic printing plate precursor is further improved in a case where the undercoat layer contains the polymer I are not clear, but it is presumed that, by disposing the undercoat layer containing the polymer I on the surface of the anodic oxide film in which the micropores having the specific structure are formed and the specific Si atomic weight is in a predetermined range, an interaction such as an attractive force is generated between the Si atoms present on the coating surface and the interior wall of the micropores and the support absorptive group of the polymer I, and the hydrophilic group of the polymer I acts on the image recording layer, and as a result, the adhesiveness between the support and the image recording layer is improved, and the printing durability is improved.

The support absorptive group refers to a group that can interact with the support such that a compound having the support absorptive group can remain on the support even in a case of a development treatment on a printing press.

Examples of the support absorptive group include an oxo acid structure of a phosphorus atom, an oxo acid salt structure of a phosphorus atom, an oxo acid ester structure of a phosphorus atom, and an oxo acid ester salt structure of a phosphorus atom. Among these, a group selected from the group consisting of a phosphonate group, a phosphate ester group, and salts thereof is preferable, and a phosphate ester group or a salt thereof is more preferable.

Examples of the hydrophilic group include a group having a zwitterionic structure (betaine structure), a group having a polyalkyleneoxy structure, a sulfonic acid group and a salt thereof, and a carboxylic acid group and a salt thereof. Among these, from the viewpoint of suppressing the residual ink on the support and further improving stain resistance to standing, a group having a zwitterionic structure or a group having a polyalkyleneoxy structure is preferable, and a group having a zwitterionic structure is more preferable.

Here, the zwitterionic structure refers to a structure having at least one cation and at least one anion. The number of cations is typically the same as the number of anions to be neutral as a whole, but in the present specification, in a case where the number of cations is not the same as the number of anions, an electric charge is cancelled by having a required amount of counter ions to be the betaine structure.

The polymer I is preferably a copolymer having a repeating unit having, in a side chain, a group selected from the group consisting of a phosphonate group, a phosphate ester group, and salts thereof, and a repeating unit having, in a side chain, at least one of a zwitterionic structure or a polyalkyleneoxy structure. In a case where the polymer I is in the above-described aspect, printing durability and stain resistance to standing are more excellent.

In the present specification, the "main chain" represents a relatively longest bonding chain in a molecule of a polymer compound constituting a resin, and the "side chain" represents a bonding chain branched from the main chain.

In addition, in the present specification, a repeating unit having a group selected from the group consisting of a phosphonate group, a phosphate ester group, and salts thereof is also referred to as a repeating unit A, and a repeating unit having a zwitterionic structure is also referred to as a repeating unit B.

From the viewpoint of printing durability, stain resistance to standing, and developability, a content of the repeating unit A in the polymer I is preferably 1% to 40% by mass, more preferably 3% to 30% by mass, and still more preferably 5% to 20% by mass with respect to the total mass of the polymer I.

From the viewpoint of stain resistance to standing and developability, a content of the repeating unit B in the polymer I is preferably 30% to 95% by mass, more preferably 40% to 90% by mass, and still more preferably 50% to 85% by mass with respect to the total mass of the polymer I.

The polymer I preferably further has a polymerizable group. That is, the polymer I is preferably a polymer having a support absorptive group, a hydrophilic group, and a polymerizable group.

The polymer I more preferably further has an ethylenically unsaturated group as the polymerizable group, and still more preferably has a repeating unit having an ethylenically unsaturated group in a side chain (also referred to as a "repeating unit C").

In a case where the polymer I contains the repeating unit C, a content of the repeating unit C is preferably 1% to 30% by mass, more preferably 3% to 20% by mass, and still more preferably 5% to 15% by mass with respect to the total mass of the polymer from the viewpoint of printing durability and stain resistance to standing.

The polymer I is preferably an acrylic resin obtained by polymerizing a (meth)acrylate compound and/or a (meth)acrylamide compound.

From the viewpoint of stain resistance to standing and developability, a total content of the repeating unit A and the repeating unit B in the polymer I is preferably 50% to 99% by mass, more preferably 70% to 97% by mass, and still more preferably 80% to 95% by mass with respect to the total mass of the polymer.

A weight-average molecular weight (Mw) of the polymer I can be optionally set depending on the performance design of the planographic printing plate precursor. From the viewpoint that printing durability and stain resistance are more excellent, the weight-average molecular weight of the polymer I is preferably 2,000 to 1,000,000, more preferably 4,000 to 500,000, and still more preferably 5,000 to 400,000.

The polymer I can also be synthesized by a known method. As a method of synthesizing the polymer I, a method of performing a radical polymerization method, and then performing a ureation reaction of reacting an isocyanate compound having an amino group and a radically polymerizable group in a polymer side chain or an amidation reaction of reacting an acid anhydride having an amino group and a radically polymerizable group in a polymer side chain is preferably used.

As the radical polymerization method, for example, methods described in Shin Kobunshi Jikken Gaku 3 (edited by The Society of Polymer Science, Kyoritsu Shuppan Co., Ltd., March 28, 1996), Kobunshi no Gosei to Gainen 1 (edited by The Society of Polymer Science, Kyoritsu Shuppan Co., Ltd., May, 1992), Shin Jikken Kagu Koushu 19, Kobunshi Kagaku (I) (edited by The Chemical Society of Japan, Maruzen Publishing Co., Ltd., November 20, 1980), and Kobunshi Gosei Kagaku (edited by Tokyo Denki University Press, September, 1995) can be applied.

The polymer I contained in the undercoat layer may be used alone or in combination of two or more kinds thereof.

A content of the polymer I in the undercoat layer is preferably 50% to 100% by mass, more preferably 60% to 100% by mass, and still more preferably 70% to 100% by mass with respect to the total mass of the total solid content in the undercoat layer excluding volatile components.

### (Method of forming undercoat layer)

A method of forming the undercoat layer is not particularly limited, and examples thereof include a method of applying a coating liquid for forming an undercoat layer, containing a component constituting the undercoat layer such as the polymer I, onto the anodic oxide film of the support.
It is preferable that the coating liquid for forming an undercoat layer contains a solvent. Examples of the solvent include water, an organic solvent such as an alcohol compound, and a mixed solvent thereof.

Examples of the method of coating the film with the coating solution for forming an undercoat layer include various known methods. Examples of the known methods include a bar coater coating method, a rotary coating method, a spray coating method, a curtain coating method, a dip coating method, an air knife coating method, a blade coating method, and a roll coating method.

A coating amount (solid content) of the undercoat layer is preferably 0.1 to 100 mg/m² and more preferably 1 to 30 mg/m².

### Protective layer

The planographic printing plate precursor preferably includes a protective layer (also referred to as "overcoat layer") on a surface of the image recording layer opposite to the support. That is, a planographic printing plate precursor including the support, the image recording layer, and the protective layer in this order is preferable.

The protective layer may have at least one of a function of suppressing a reaction inhibiting image formation by shielding oxygen, a function of preventing occurrence of scratches in the image recording layer, or a function of preventing ablation during exposure to a high-illuminance laser.

Protective layers having the characteristics are described in, for example, US3458311A and JP1980-049729B (JP-S55-049729B). As an oxygen-impermeable polymer used in the protective layer, any of a water-soluble polymer or a hydrophobic polymer (water-insoluble polymer) can be appropriately selected and used, and two or more kinds thereof can be mixed and used as necessary; but from the viewpoint of on-press developability, a water-soluble polymer is preferable.

In the present specification, the water-soluble polymer means a polymer having a solubility of more than 5% by mass in pure water at 25°C.

Examples of the water-soluble polymer used in the protective layer include polyvinyl alcohol, modified polyvinyl alcohol, polyvinylpyrrolidone, a cellulose derivative, polyethylene glycol, and poly(meth)acrylonitrile.

In addition, the water-soluble polymer preferably includes at least one selected from the group consisting of modified polyvinyl alcohol and a cellulose derivative.

As the modified polyvinyl alcohol, an acid-modified polyvinyl alcohol having a carboxy group or a sulfo group is preferably used. Specific examples thereof include modified polyvinyl alcohols described in JP2005-250216A and JP2006-259137A.

Examples of the cellulose derivative include methyl cellulose, hydroxypropyl methyl cellulose, and carboxymethyl cellulose.

Among the above water-soluble polymers to be incorporated into the outermost layer, polyvinyl alcohol is preferable, and polyvinyl alcohol having a saponification degree of 50% or more is more preferable.

The saponification degree is preferably 60% or more, more preferably 70% or more, and even more preferably 85% or more. The upper limit of the saponification degree is not particularly limited, and may be 100% or less.

The saponification degree is measured according to the method described in JIS K 6726: 1994.

As an aspect of the protective layer, for example, an aspect in which the protective layer contains polyvinyl alcohol and polyethylene glycol is also preferable.

In a case where the protective layer contains a water-soluble polymer, a content of the water-soluble polymer is preferably 1% to 99% by mass, more preferably 3% to 97% by mass, and still more preferably 5% to 95% by mass with respect to the total mass of the protective layer.

The protective layer preferably contains a hydrophobic polymer.

The hydrophobic polymer refers to a polymer which is dissolved less than 5 g or is not dissolved in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

The hydrophobic polymer preferably includes a polyvinylidene chloride resin. In addition, the hydrophobic polymer preferably includes a styrene-acrylic copolymer (also referred to as a styrene acrylic resin).

From the viewpoint of on-press developability, the hydrophobic polymer is preferably hydrophobic polymer particles.

Only one type of hydrophobic polymer may be used, or two or more types of hydrophobic polymers may be used in combination.

In a case where the protective layer contains a hydrophobic polymer, a content of the hydrophobic polymer is preferably 1% to 70% by mass, more preferably 5% to 50% by mass, and still more preferably 10% to 40% by mass with respect to the total mass of the protective layer.

From the viewpoint of improving visibility of the exposed portion, the protective layer preferably contains a color forming substance precursor. The color forming substance precursor means a compound having a property of forming color by a stimulus such as light and acid and changing the color of the image recording layer. Examples of the color forming substance precursor include an infrared absorber and an acid color-forming agent.

The protective layer preferably contains, as the color forming substance precursor, an infrared absorber, and more preferably contains a decomposition-type infrared absorber.

The infrared absorber and the acid color-forming agent contained in the protective layer are the same as the infrared absorber and the acid color-forming agent contained in the image recording layer, including preferred aspects thereof.

The color forming substance precursor contained in the protective layer may be used alone, or in combination of two or more kinds thereof.

From the viewpoint of color formability, a content of the color forming substance precursor in the protective layer is preferably 0.10% to 50% by mass, more preferably 0.50% to 30% by mass, and still more preferably 1.0% to 20% by mass with respect to the total mass of the protective layer.

From the viewpoint of development defect suppressiveness, it is preferable that the protective layer contain a filler.

Examples of the filler include inorganic particles, organic resin particles, and an inorganic lamellar compound. Among these, an inorganic lamellar compound is preferable. By using an inorganic lamellar compound, it is possible to effectively inhibit an attachment re-attached from the roll surface from being directly attached to the surface of the image recording layer.

The inorganic lamellar compound refers to particles having thin flat plate shapes, and examples thereof include mica groups such as natural mica and synthetic mica, talc represented by a formula 3MgO·4SiO·H₂O, taeniolite, montmorillonite, saponite, hectorite, and zirconium phosphate.

As the inorganic lamellar compound, a mica compound is preferably used. Examples of the mica compound include a mica compound represented by a formula of A(B,C)₂₋₅D₄O₁₀(OH,F,O)₂ [here, A is any of K, Na, and Ca, B and C are any of Fe(II), Fe(III), Mn, Al, Mg, and V, and D is Si or Al.A mica group such as natural mica and synthetic mica represented by the formula is an exemplary example.

Examples of the inorganic lamellar compound include the inorganic lamellar compound described in WO2020/262692A, the description of which is incorporated herein by reference.

Examples of the inorganic particles include metal oxide particles such as silica particles. The following inorganic lamellar compound is not included in the inorganic particles.

Examples of the organic resin particles include crosslinked resin particles.

A content of the filler (preferably, the inorganic lamellar compound) is preferably 1% to 60% by mass and more preferably 3% to 50% by mass with respect to the total mass of the protective layer. In a case where the inorganic lamellar compound is contained in the above-described range, the oxygen barrier properties are improved, good sensitivity can be obtained, and a decrease in ink receptivity can be prevented.

The protective layer may contain a known additive such as a plasticizer for imparting flexibility and a surfactant for improving coatability, in addition to the above-described components. In addition, the oil sensitizing agent described above regarding the image recording layer may be incorporated into the protective layer.

The protective layer can be formed by a known method of applying a composition containing the above-described components. A coating amount (expressed in terms of solid contents) of the protective layer is preferably 0.0 to 10 g/m², more preferably 0.02 to 3 g/m², and still more preferably 0.02 to 1 g/m².

A film thickness of the protective layer in the planographic printing plate precursor is not particularly limited, but is preferably 0.1 to 5.0 µm and more preferably 0.3 to 4.0 µm.

The planographic printing plate precursor may further include a known layer laminated on the planographic printing plate precursor, other than the above. For example, a back coating layer may be provided on the surface of the support opposite to the image recording layer as necessary.

### [Laminate]

The planographic printing plate precursor may constitute a laminate in which a plurality of planographic printing plate precursors are laminated.

It is preferable that the laminate in which a plurality of planographic printing plate precursors are laminated further includes a protective material which protects the planographic printing plate precursors. The planographic printing plate precursor is in a form of one thin plate adopting a metal as the support. Therefore, in a case where scratches or deformation occurs in the corners, sides, inside, or the like of the planographic printing plate precursor, unfortunately, images are likely to be blurred by photosensitization, or ink is likely to be non-uniformly distributed by printing. Therefore, in a case of constituting a laminate in which a plurality of precursors are laminated, it is preferable to dispose a protective material for each predetermined number of precursors to protect the precursors.

For example, by packaging a laminate including a plurality of planographic printing plate precursors and a protective material with a packaging material to form a package, and handling the package (transportation, storage, and the like), deformation (bending and the like) of the precursors during handling is less likely to occur, and damage to the precursors is suppressed. In addition, even in a case where an external force acts on the package, since a part of the external force is absorbed by the protective material, deformation and scratches of the precursors are suppressed.

The disposition of the protective material in the laminate is not particularly limited, and examples thereof include the uppermost portion of the laminate, between the laminated planographic printing plate precursors, and the lowermost portion of the laminate. The protective material is preferably disposed at least at the uppermost portion of the laminate, and more preferably disposed at least at the uppermost portion and the lowermost portion.

A material of the protective material is not particularly limited, and examples thereof include thick paper, cardboard, and plastic. Among these, from the viewpoint of suppressing development defect, cardboard or plastic is preferable and plastic is more preferable. Examples of the plastic include polyester, polycarbonate, and polyolefin; and polyester is preferable.

A size (length and width) and a thickness of the protective material are not particularly limited and can be appropriately selected according to the planographic printing plate precursor to be protected.

From the viewpoint of suppressing development defect, a moisture content of the protective material is preferably 10% by mass or less, more preferably 7% by mass or less, and particularly preferably 3% by mass or less. The lower limit value of the moisture content is 0% by mass. The moisture content (equilibrium moisture content) of the protective material is measured according to the method described in JIS P 8202 (1998).

The laminate may have an interleaving paper between the planographic printing plate precursors.

Examples of a material of the interleaving paper include paper in which 100% by mass of wood pulp is used, paper in which wood pulp and synthetic pulp are used in combination, and paper in which a low-density polyethylene layer or a high-density polyethylene layer is provided on a surface thereof.

In addition, the entire laminate may be packaged with a known packaging material.

### [Method of manufacturing planographic printing plate precursor]

Examples of a method of manufacturing the planographic printing plate precursor according to the embodiment of the present invention include a method including a step of producing a support including an aluminum alloy plate and an anodic oxide film, and a step of forming an image recording layer on a surface of the produced support on the anodic oxide film side.

The step of producing the support is described in <Method of producing support> above, and the step of forming the image recording layer is described in <Method of forming image recording layer> above.

As necessary, after the step of producing the support, a step of forming an undercoat layer on the surface of the obtained support on the anodic oxide film side may be performed, and then the above-described step of forming the image recording layer on the surface of the formed undercoat layer may be performed.

In addition, after performing the above-described step of forming the image recording layer, a step of forming a protective layer on the surface of the formed image recording layer may be performed.

The method of forming the undercoat layer and the step of forming the protective layer are as described above.

### [Manufacturing method of planographic printing plate and printing method]

A manufacturing method of a planographic printing plate using the planographic printing plate precursor according to the embodiment of the present invention and a printing method using the planographic printing plate according to the embodiment of the present invention will be described.

The manufacturing method of a planographic printing plate according to the embodiment of the present invention includes a step (exposure step) of exposing the image recording layer of the planographic printing plate precursor in an imagewise manner (imagewise exposure) to form an exposed portion and a non-exposed portion, and a step (on-press development step) of supplying at least one of a printing ink or a dampening water on a printing press to remove the non-exposed portion of the imagewise-exposed image recording layer and to manufacture a planographic printing plate.

The printing method according to the embodiment of the present invention includes a step (exposure step) of exposing the image recording layer of the planographic printing plate precursor in an imagewise manner (imagewise exposure) to form an exposed portion and a non-exposed portion, a step (on-press development step) of supplying at least one of printing ink or dampening water on a printing press to remove the non-exposed portion of the image recording layer and to manufacture a planographic printing plate; and a step (printing step) of performing printing using the manufactured planographic printing plate.

Hereinafter, each of the above-described steps will be described in detail.

### <Exposing step>

The manufacturing method of a planographic printing plate and the printing method include an exposure step of image-exposing the image recording layer of the planographic printing plate precursor to form an exposed portion and a non-exposed portion.

The imagewise exposure is performed by laser exposure through a transparent original picture having a line image or a halftone image or by laser beam scanning using digital data.

The wavelength of the light source for the image exposure is preferably 750 to 1,400 nm. In a case where a light source which emits light having a wavelength of 750 to 1,400 nm is used, it is preferable to use an image recording layer containing an infrared absorber having absorption in this wavelength range.

As the light source of emitting light with a wavelength of 750 to 1400 nm, a solid-state laser or a semiconductor laser that radiates infrared rays is exemplified. The output of the infrared laser is preferably 100 mW or more, the exposure time per one pixel is preferably equal to or less than 20 microseconds, and the irradiation energy quantity is preferably 10 to 300 mJ/cm². For the purpose of reducing the exposure time, it is preferable to use a multi-beam laser device. The exposure mechanism may be an internal drum system, an external drum system, a flat bed system, or the like.

The imagewise exposure can be performed using a plate setter according to a usual method. The imagewise exposure may be performed on a printing press after the planographic printing plate precursor is mounted on the printing press.

### <On-press development step>

In the on-press development step, at least one of printing ink or dampening water is supplied to the imagewise-exposed planographic printing plate precursor on a printing press, and the image recording layer in the non-exposed portion is removed, thereby manufacturing a planographic printing plate.

That is, in a case where the planographic printing plate precursor is imagewise-exposed and directly mounted on the printing press without performing any developer treatment or the planographic printing plate precursor is mounted on the printing press, imagewise-exposed on the printing press, and printed by supplying printing ink and dampening water, in the non-exposed portion, at the initial stage of the printing, the non-exposed portion in the image recording layer is dissolved or dispersed in the supplied printing ink and/or dampening water to be removed, and thus the hydrophilic surface in the removed portion is exposed. Meanwhile, the image recording layer cured by exposure forms an oil-based ink receiving unit having a lipophilic surface in the exposed portion. The printing ink or dampening water may be supplied first to the plate surface, but the printing ink is preferably first supplied from a viewpoint of preventing the dampening water from being contaminated by the removed image recording layer component.

In this manner, the planographic printing plate precursor is manufactured on the printing press by on-press development and is used as it is for printing a large number of sheets.

### <Printing step>

The printing method includes a printing step of printing a recording medium using the planographic printing plate manufactured by the exposure step and the on-press development step.

As printing ink used in the printing step, various known inks can be used as desired. As the printing ink, an oil-based ink or an ultraviolet-curable ink (UV ink) is preferable.

In the above-described printing step, dampening water may be supplied as necessary.

The above-described printing step may be successively performed after the above-described on-press development step without stopping the printing press.

As the recording medium, a known recording medium can be used as desired.

In the manufacturing method of a planographic printing plate and the printing method, the entire surface of the planographic printing plate precursor or the planographic printing plate may be heated at any stage of before the exposure, during exposure, from the exposure to the development, or after the development, as necessary. By such heating, an image forming reaction in the image recording layer is promoted, and advantages such as improvement in sensitivity or printing durability and stabilization of sensitivity can be obtained.

In a case where the planographic printing plate precursor is heated before the development, since it is possible to prevent problems such as curing of the non-exposed portion, it is preferable to heat the planographic printing plate precursor under mild conditions of 150°C or lower.

In a case where the planographic printing plate is heated after the development, since a sufficient image reinforcing effect can be obtained and problems such as deterioration of the support and thermal decomposition of the image area can be suppressed, it is preferable to heat the planographic printing plate under extremely severe conditions, for example, in a range of 100°C to 500°C.

### Examples

Hereinafter, the present invention will be described in detail with reference to Examples, but the materials, the amounts and proportions of the materials used, the details of treatments, the procedure of treatments, and the like shown in Examples can be appropriately modified as long as the gist of the present invention is maintained. Accordingly, the scope of the present invention should not be construed as being limited by the specific examples shown below.

For the polymer, the molecular weight is a weight-average molecular weight (Mw), and the ratio of repeating units is a molar percentage. In addition, the notation of "%" represents "% by mass", and the notation of "part" represents "part by mass".

### [Production Example 1: Production of support]

The following treatment was performed on an aluminum plate (aluminum alloy plate) having a thickness of 0.3 mm and a material 1S to produce a support 1. Moreover, during all treatment steps, a water washing treatment was performed, and liquid cutting was performed using a nip roller after the water washing treatment.

### <Alkaline etching treatment (1)>

An aqueous solution of caustic soda having a caustic soda concentration of 26% by mass and an aluminum ion concentration of 6.5% by mass was sprayed onto the aluminum plate at a temperature of 70°C, thereby performing an etching treatment. Thereafter, the aluminum plate was washed with water using a spray. The dissolved aluminum amount of the surface to be subjected to an electrochemical roughening treatment was 5 g/m².

### <Desmutting treatment (1) using acidic aqueous solution>

Next, a desmutting treatment was performed using an aqueous acidic solution. Specifically, the desmutting treatment was performed by spraying the acidic aqueous solution to the aluminum plate for 3 seconds using a spray. As the acidic aqueous solution used for the desmutting treatment, an aqueous solution containing 150 g/L of sulfuric acid was used. The liquid temperature was 30°C.

### <Hydrochloric acid electrolytic treatment>

Next, a hydrochloric acid electrolytic treatment was performed using an alternating current with an electrolytic solution having a hydrochloric acid concentration of 13 g/L, an aluminum ion concentration of 15 g/L, and a sulfuric acid concentration of 1.0 g/L. The liquid temperature of the electrolytic solution was 25°C. The aluminum ion concentration was adjusted by adding aluminum chloride.

The waveform of the AC current was a sine wave in which the positive and negative waveforms were symmetrical, the frequency was 50 Hz, the ratio between the anodic reaction time and the cathodic reaction time in one cycle of the AC current was 1:1, and the current density was 35 A/dm² in terms of the peak current value of the AC current waveform. Further, the sum of the electric quantity for the anodic reaction of the aluminum plate was 300 C/dm², and the electrolytic treatment was performed four times at energization intervals of 2.5 seconds for each electric quantity of 75 C/dm². A carbon electrode was used as a counter electrode of the aluminum plate. Thereafter, the water washing treatment was performed.

### <Alkali etching treatment (2)>

An aqueous solution of caustic soda having a caustic soda concentration of 5% by mass and an aluminum ion concentration of 0.5% by mass was sprayed onto the aluminum plate after the hydrochloric acid electrolytic treatment at a temperature of 45°C to perform an etching treatment. An amount of aluminum dissolved in the surface subjected to the hydrochloric acid electrolytic treatment was 0.2 g/m². Thereafter, the water washing treatment was performed.

### <Desmutting treatment (2) using acidic aqueous solution>

Next, a desmutting treatment was performed using an aqueous acidic solution. Specifically, the desmutting treatment was performed by spraying the acidic aqueous solution to the aluminum plate for 3 seconds using a spray. In the desmutting treatment, an aqueous solution having a sulfuric acid concentration of 170 g/L and an aluminum ion concentration of 5 g/L was used as aqueous acidic solution. A liquid temperature thereof was 35°C.

### <First anodization treatment>

The first anodization treatment was performed using an anodization device for direct current electrolysis having the structure shown in FIG. 6. An anodic oxide film having a predetermined film thickness was formed by performing an anodization treatment under conditions listed in Table 1. A concentration of sulfuric acid in the first anodization treatment was 170 g/L.

In an anodization treatment device 610 illustrated in FIG. 6, an aluminum plate 616 is transported as indicated by the arrow in FIG. 6. In a power supply tank 612 storing an electrolytic solution 618, the aluminum plate 616 is positively (+) charged by a power supply electrode 620. Further, the aluminum plate 616 is transported upward by a roller 622 in the power supply tank 612, redirected downward by a nip roller 624, transported toward an electrolytic treatment tank 614 in which an electrolytic solution 626 is stored, and redirected to the horizontal direction by a roller 628. Subsequently, the aluminum plate 616 is negatively (-) charged by an electrolytic electrode 630. As a result, an anodic oxide film is formed on the surface of the aluminum plate 616. The aluminum plate 616 exits from the electrolytic treatment tank 614 and is then transported for the next step. In the anodization device 610, direction changing means is formed of the roller 622, the nip roller 624, and the roller 628. The aluminum plate 616 is transported in a mountain shape and an inverted U shape by the roller 622, the nip roller 624, and the roller 628 in an inter-tank portion between the power supply tank 612 and the electrolytic treatment tank 614. The power supply electrode 620 and the electrolytic electrode 630 were connected to a DC power source 634. A tank wall 632 was disposed between the power supply tank 612 and the electrolytic treatment tank 614.

### <Pore widening treatment>

The aluminum plate subjected to the first anodization treatment was immersed in a caustic soda aqueous solution having a temperature of 40°C, a caustic soda concentration of 5% by mass, and an aluminum ion concentration of 0.5% by mass, and subjected to a pore widening treatment for a treatment time shown in Table 1. Thereafter, the aluminum plate was washed with water using a spray.

### <Second anodization treatment>

The aluminum plate subjected to the pore widening treatment was subjected to a second anodization treatment using an anodization device for direct current electrolysis having a structure shown in FIG. 6. More specifically, an anodization treatment was performed under the conditions described in the column of "Second anodization treatment" in Table 1 to form an anodic oxide film having a predetermined structure. A concentration of sulfuric acid in the second anodization treatment was 170 g/L.

### <Silicate treatment>

The aluminum plate subjected to the second anodization treatment was subjected to a silicate treatment to obtain a support 1. More specifically, the aluminum plate subjected to the second anodization treatment was immersed in a No. 3 sodium silicate aqueous solution having a concentration of 5% by mass and a liquid temperature of 40°C for 12 seconds.

### [Production Examples 2 to 29]

Supports 2 to 29 were produced according to the same procedure as in Production Example 1, except that the conditions of each treatment performed in Production Example 1 were changed to the conditions shown in Table 1.

In the table, the column of "Concentration (% by mass)" of "Silicate treatment" indicates a percentage of the content of the alkali metal silicate with respect to the total mass of the No. 3 sodium silicate aqueous solution used for the silicate treatment.

**[Table 1]**

| Table 1 | Support | Alkali etching treatment (1) | Electrochemical roughening treatment | | | Alkali etching treatment (2) | First anodization treatment step | | | | |
|---|---|---|---|---|---|---|---|---|---|---|---|
| | No. | (g/m²) | Concentration of hydrochloric acid (g/L) | Liquid temperature (°C) | Electric quantity (c/dm²) | (g/m²) | Electrolytic solution | Concentration of liquid (g/L) | Liquid temperature (°C) | current density (A/dm²) | Electric quantity (c/dm²) |
| Production Example 1 | 1 | 5 | 13 | 25 | 330 | 0.1 | | 170 | 40 | 20 | 45 |
| Production Example 2 | 2 | 5 | 13 | 25 | 330 | 0.1 | | 170 | 40 | 20 | 45 |
| Production Example 3 | 3 | 5 | 13 | 25 | 330 | 0.1 | | 170 | 40 | 20 | 45 |
| Production Example 4 | 4 | 5 | 13 | 25 | 330 | 0.1 | | 170 | 40 | 20 | 45 |
| Production Example 5 | 5 | 5 | 13 | 25 | 330 | 0.1 | | 170 | 40 | 20 | 45 |
| Production Example 6 | 6 | 5 | 13 | 25 | 330 | 0.1 | | 170 | 40 | 20 | 45 |
| Production Example 7 | 7 | 5 | 13 | 25 | 330 | 0.1 | | 170 | 40 | 20 | 45 |
| Production Example 8 | 8 | 5 | 13 | 25 | 330 | 0.1 | | 170 | 40 | 20 | 45 |
| Production Example 9 | 9 | 5 | 13 | 25 | 330 | 0.1 | | 170 | 40 | 20 | 45 |
| Production Example 10 | 10 | 5 | 13 | 25 | 330 | 0.1 | | 170 | 40 | 20 | 45 |
| Production Example 11 | 11 | 5 | 13 | 25 | 330 | 0.1 | | 170 | 40 | 7 | 45 |
| Production Example 12 | 12 | 5 | 13 | 25 | 330 | 0.1 | | 170 | 40 | 10 | 45 |
| Production Example 13 | 13 | 5 | 13 | 25 | 330 | 0.1 | | 170 | 40 | 30 | 45 |
| Production Example 14 | 14 | 5 | 13 | 25 | 330 | 0.1 | | 170 | 40 | 60 | 45 |
| Production Example 15 | 15 | 5 | 13 | 25 | 330 | 0.1 | | 170 | 40 | 20 | 27 |
| Production Example 16 | 16 | 5 | 13 | 25 | 330 | 0.1 | | 170 | 40 | 20 | 36 |
| Production Example 17 | 17 | 5 | 13 | 25 | 330 | 0.1 | | 170 | 40 | 20 | 135 |
| Production Example 18 | 18 | 5 | 13 | 25 | 330 | 0.1 | | 170 | 40 | 20 | 225 |
| Production Example 19 | 19 | 5 | 13 | 25 | 330 | 0.1 | | 170 | 40 | 20 | 45 |
| Production Example 20 | 20 | 5 | 13 | 25 | 330 | 0.1 | | 170 | 40 | 20 | 45 |
| Production Example 21 | 21 | 5 | 13 | 25 | 330 | 0.1 | | 200 | 35 | 3 | 45 |
| Production Example 22 | 22 | 5 | 13 | 25 | 330 | 0.1 | | 100 | 35 | 3 | 45 |
| Production Example 23 | 23 | 5 | 13 | 25 | 330 | 0.1 | | 170 | 40 | 20 | 45 |
| Production Example 24 | 24 | 5 | 13 | 25 | 330 | 0.1 | | 170 | 40 | 20 | 45 |
| Production Example 25 | 25 | 5 | 13 | 25 | 330 | 0.1 | | 170 | 40 | 20 | 45 |
| Production Example 26 | 26 | 5 | 13 | 25 | 330 | 0.1 | | 170 | 40 | 20 | 45 |
| Production Example 27 | 27 | 5 | 13 | 25 | 330 | 0.1 | | 170 | 40 | 20 | 45 |
| Production Example 28 | 28 | 5 | 13 | 25 | 330 | 0.1 | | 170 | 40 | 20 | 45 |
| Production Example 29 | 29 | 5 | 13 | 25 | 330 | 0.1 | | 170 | 40 | 20 | 45 |

**[Table 2]**

| Table 1 (continue) | Pore widening treatment | Second anodization treatment step | | | | Silicate treatment | | | |
|---|---|---|---|---|---|---|---|---|---|
| | Treatment time (second) | Electrolytic solution | Liquid temperature (°C) | Current density (A/dm²) | Electric quantity (c/dm²) | Type of treatment liquid | Concentration (% by mass) | Liquid temperature (°C) | Treatment time (second) |
| Production Example 1 | 5 | Sulfuric acid | 40 | 20 | 600 | No. 3 sodium silicate | 5 | 45 | 3 |
| Production Example 2 | 5 | Sulfuric acid | 40 | 20 | 600 | No. 3 sodium silicate | 5 | 45 | 10 |
| Production Example 3 | 5 | Sulfuric acid | 40 | 20 | 600 | No. 3 sodium silicate | 5 | 45 | 12 |
| Production Example 4 | 5 | Sulfuric acid | 40 | 20 | 600 | No. 3 sodium silicate | 5 | 55 | 12 |
| Production Example 5 | 5 | Sulfuric acid | 40 | 20 | 600 | No. 3 sodium silicate | 5 | 60 | 12 |
| Production Example 6 | 5 | Sulfuric acid | 40 | 20 | 600 | No. 3 sodium silicate | 5 | 70 | 12 |
| Production Example 7 | 5 | Sulfuric acid | 40 | 20 | 600 | No. 3 sodium silicate | 5 | 70 | 12 |
| Production Example 8 | 5 | Sulfuric acid | 40 | 20 | 600 | No. 3 sodium silicate | 5 | 70 | 20 |
| Production Example 9 | 5 | Sulfuric acid | 40 | 20 | 600 | No. 3 sodium silicate | 5 | 70 | 40 |
| Production Example 10 | 5 | Sulfuric acid | 40 | 20 | 600 | No. 3 sodium silicate | 5 | 70 | 60 |
| Production Example 11 | 1 | Sulfuric acid | 40 | 20 | 600 | No. 3 sodium silicate | 5 | 65 | 12 |
| Production Example 12 | 3 | Sulfuric acid | 40 | 20 | 600 | No. 3 sodium silicate | 5 | 65 | 12 |
| Production Example 13 | 6 | Sulfuric acid | 40 | 20 | 600 | No. 3 sodium silicate | 5 | 65 | 12 |
| Production Example 14 | 9 | Sulfuric acid | 40 | 20 | 600 | No. 3 sodium silicate | 5 | 65 | 12 |
| Production Example 15 | 5 | Sulfuric acid | 40 | 20 | 600 | No. 3 sodium silicate | 5 | 65 | 12 |
| Production Example 16 | 5 | Sulfuric acid | 40 | 20 | 600 | No. 3 sodium silicate | 5 | 65 | 12 |
| Production Example 17 | 5 | Sulfuric acid | 40 | 20 | 600 | No. 3 sodium silicate | 5 | 65 | 12 |
| Production Example 18 | 5 | Sulfuric acid | 40 | 20 | 600 | No. 3 sodium silicate | 5 | 65 | 12 |
| Production Example 19 | 5 | Sulfuric acid | 55 | 20 | 600 | No. 3 sodium silicate | 5 | 65 | 12 |
| Production Example 20 | 5 | Sulfuric acid | 70 | 20 | 600 | No. 3 sodium silicate | 5 | 65 | 12 |
| Production Example 21 | - | Sulfuric acid | 40 | 20 | 600 | No. 3 sodium silicate | 5 | 65 | 12 |
| Production Example 22 | - | Sulfuric acid | 40 | 20 | 600 | No. 3 sodium silicate | 5 | 65 | 12 |
| Production Example 23 | 5 | Sulfuric acid | 40 | 20 | 600 | No. 3 sodium silicate | 5 | 65 | 12 |
| Production Example 24 | 5 | Sulfuric acid | 40 | 20 | 600 | No. 3 sodium silicate | 5 | 65 | 12 |
| Production Example 25 | 5 | Sulfuric acid | 40 | 20 | 600 | No. 3 sodium silicate | 5 | 65 | 12 |
| Production Example 26 | - | Sulfuric acid | 40 | 20 | 600 | No. 3 sodium silicate | 5 | 30 | 2 |
| Production Example 27 | - | Sulfuric acid | 40 | 20 | 600 | No. 3 sodium silicate | 5 | 45 | 2 |
| Production Example 28 | 5 | Sulfuric acid | 40 | 20 | 600 | No. 3 sodium silicate | 5 | 45 | 2 |
| Production Example 29 | 5 | Sulfuric acid | 40 | 20 | 600 | No. 3 sodium silicate | 5 | 70 | 150 |

### [Preparation of coating liquid for undercoat layer]

The following components were mixed to prepare each of coating liquids A to C for an undercoat layer, used for forming an undercoat layer.

### (Coating solution A for undercoat layer)

· Compound (1) for undercoat layer: 0.010 parts
· CHELEST (registered trademark) 400 (chelating agent, manufactured by CHELEST CORPORATION): 0.0280 parts
· CHELEST 3EAF (chelating agent, manufactured by CHELEST CORPORATION): 0.0499 parts
· Surfactant (EMALEX (registered trademark) 710, manufactured by Nihon Emulsion Co., Ltd.): 0.00159 parts
· Preservative (BIOHOPE (registered trademark) L, manufactured by K·I Chemical Industry Co., LTD.): 0.00149 parts
· Water: 2.8219 parts

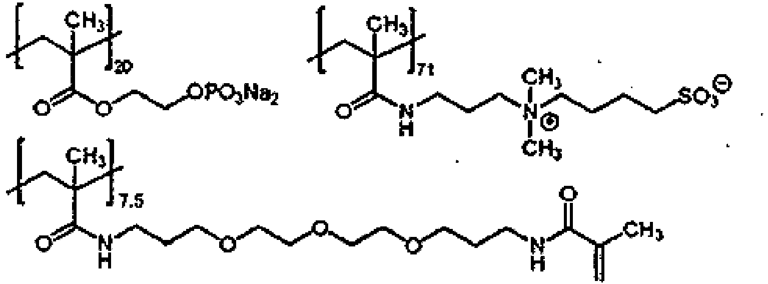

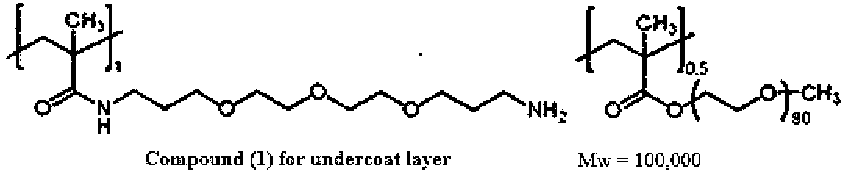

### (Coating solution B for undercoat layer)

· Compound (2) for undercoat layer: 0.010 parts
· CHELEST 400 (chelating agent, manufactured by CHELEST CORPORATION): 0.0280 parts
· CHELEST 3EAF (chelating agent, manufactured by CHELEST CORPORATION): 0.0499 parts
· Surfactant (EMALEX 710, manufactured by NIHON EMULSION Co., Ltd.): 0.00159 parts
· Preservative (BIOHOPE L, manufactured by K·I Chemical Industry Co., LTD.): 0.00149 parts
· Water: 2.8219 parts

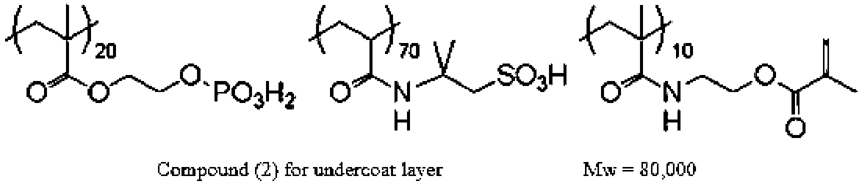

· Compound (3) for undercoat layer: 0.010 parts
· CHELEST 400 (chelating agent, manufactured by CHELEST CORPORATION): 0.0280 parts
· CHELEST 3EAF (chelating agent, manufactured by CHELEST CORPORATION): 0.0499 parts
· Surfactant (EMALEX 710, manufactured by NIHON EMULSION Co., Ltd.): 0.00159 parts
· Preservative (BIOHOPE L, manufactured by K.I Chemical Industry Co., LTD.): 0.00149 parts
· Water: 2.8219 parts

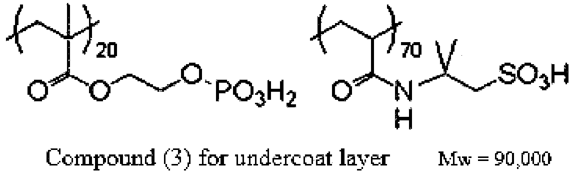

### [Preparation of coating liquid for image recording layer]

### <Image recording layer coating liquid A>

The following components are mixed to prepare an image recording layer coating liquid A.
· Infrared absorber (IR-1): 0.0200 parts
· Infrared absorber (IR-2): 0.0050 parts
· Acid color forming agent (S-1): 0.0300 parts
· Acid color forming agent (S-2): 0.0120 parts
· Onium-based polymerization initiator (I-1): 0.0981 parts
· Borate compound (sodium tetraphenylborate (TPB)): 0.0270 parts
· Polymerizable compound (M-4, 70%): 0.3536 parts
· Fluorine-based surfactant (1) (the following structure)0.004 parts
· Anionic surfactant (A-1, 30%): 0.1620 parts
· 2-Butanone: 5.3155 parts
· 1-Methoxy-2-propanol: 2.8825 parts
· Methanol: 2.3391 parts
· Microgel liquid (5): 2.8779 parts

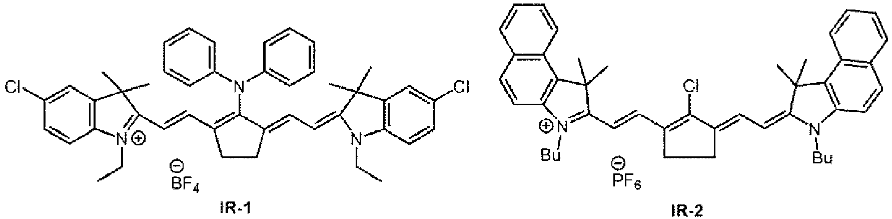

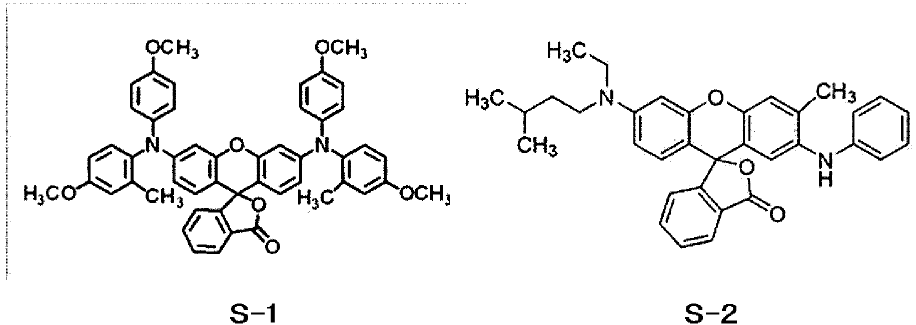

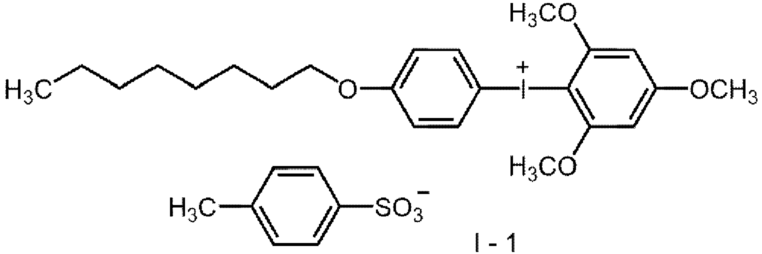

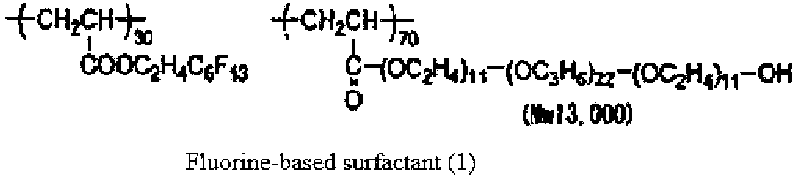

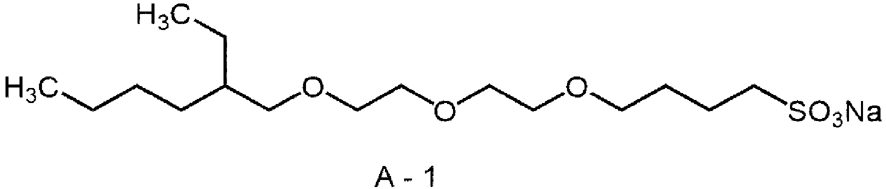

### (Synthesis of polymerizable compound M-4)

A mixed solution of TAKENATE (registered trademark) D-160N (polyisocyanate-trimethylolpropane adduct, manufactured by Mitsui Chemicals, Inc., 4.7 parts), ARONIX (registered trademark) M-403 (manufactured by TOAGOSEI CO., LTD., an amount at which the NCO value of TAKENATE D-160N and the hydroxyl value of ARONIX M-403 are 1:1), t-butylbenzoquinone (0.02 parts), and methyl ethyl ketone (11.5 parts) was heated to 65°C. NEOSTANN (registered trademark) U-600 (bismuth-based polycondensation catalyst, manufactured by Nitto Kasei Co., Ltd., 0.11 parts) was added to the reaction solution, and the mixture was heated at 65°C for 4 hours. The reaction solution was cooled to room temperature (25°C), and methyl ethyl ketone was added thereto, thereby synthesizing a urethane acrylate (polymerizable compound M-4) solution having a solid content of 50% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight of the polymerizable compound M-4 was 20,000.

### (Preparation of microgel liquid (5))

The following components were mixed to prepare a microgel liquid (5) used for preparing the image recording layer coating liquid A.
· Microgel (4) (concentration of solid contents: 21.8% by mass) 2.2707 parts
· 1-Methoxy-2-propanol 0.6072 parts

### - Preparation of microgel (4) -

The following oil-phase components and water-phase components were mixed together and emulsified at 12,000 rpm for 10 minutes by using a homogenizer. The obtained emulsion was stirred at 45°C for 4 hours, 5.20 parts of a 10% by mass aqueous solution of 1,8-diazabicyclo[5.4.0]undec-7-ene-octylate (U-CAT SA102, manufactured by San-Apro Ltd.) was added thereto, the mixture was stirred at room temperature for 30 minutes, and allowed to stand at 45°C for 24 hours. Distilled water was added thereto such that the concentration of solid contents was adjusted to 21.8% by mass, thereby obtaining an aqueous dispersion liquid of a microgel (4). In a case where a volume average particle diameter was measured by a light scattering method using a dynamic light scattering particle size distribution analyzer LB-500 (manufactured by HORIBA, Ltd.), the volume average particle diameter was 0.28 µm.

### (Oil phase components)

(Component 1) ethyl acetate:12.0 parts
(Component 2) adduct (50 mass% ethyl acetate solution, manufactured by Mitsui Chemicals, Inc.) obtained by adding trimethylolpropane (6 mol) and xylene diisocyanate (18 mol) and adding methyl one-terminal polyoxyethylene (1 mol, repetition number of oxyethylene units: 90) thereto:
   3.76 parts
(Component 3) polyvalent isocyanate compound (1) (as 50% by mass ethyl acetate solution):
   15.0 parts
(Component 4) 65% by mass of solution of dipentaerythritol pentaacrylate (SR-399, manufactured by Sartomer Japan Inc.) in ethyl acetate: 11.54 parts
(Component 5) 10% solution of sulfonate type surfactant (PIONINE A-41-C, manufactured by TAKEMOTO OIL & FAT Co., Ltd.) in ethyl acetate: 4.42 parts

### (Water phase component)

Distilled water46.87 parts

### - Preparation of polyvalent isocyanate compound (1) -

Bismuth tris(2-ethylhexanoate) (NEOSTAN U-600, manufactured by NITTO KASEI Co., Ltd., 0.043 parts) was added to an ethyl acetate (25.31 g) suspension solution of 17.78 parts (80 molar equivalents) of isophorone diisocyanate and 7.35 parts (20 molar equivalents) of the following polyhydric phenol compound (1), and the obtained solution was stirred. The reaction temperature was set to 50° in a case of heat generation being subsided, and the solution was stirred for 3 hours, thereby obtaining an ethyl acetate (50% by mass) solution of a polyvalent isocyanate compound (1).

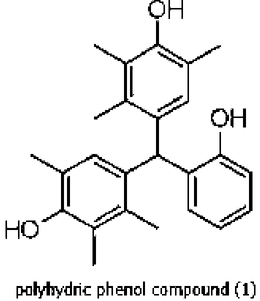

### <Image recording layer coating solution B>

The following components were mixed to prepare an image recording layer coating liquid B.
· 2-Butanone: 5.3155 parts
· 1-Methoxy-2-propanol: 2.8825 parts
· Methanol: 2.3391 parts
· Polymerizable compound (the above-described M-4, 70%): 0.3571 parts
· Electron-accepting polymerization initiator (the above-described I-1): 0.025 parts
· Borate compound (sodium tetraphenylborate (TPB)): 0.030 parts
· Cleavable color-developing compound (infrared absorber) (the following IR-3): 0.035 parts
· Tricresyl phosphate: 0.0125 parts
· Anionic surfactant (the above-described A-1): 0.0162 parts
· Microgel liquid (5): 2.8779 parts
· Fluorine-based surfactant (1) (the above-described structure): 0.0042 parts

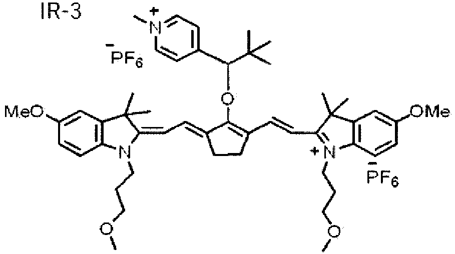

### [Preparation of protective layer coating solution]

The following components were mixed to prepare a protective layer coating liquid A used for forming a protective layer.
· Water: 1.0161 parts
· METOLOSE (registered trademark) SM04 (methyl cellulose, manufactured by Shin-Etsu Chemical Co., Ltd., methoxy substitution degree = 1.8): 0.0600 parts
· FS-102 (styrene-acrylic resin, manufactured by Nippon Paint Industrial Coatings Co., Ltd., Tg = 103°C, 17% aqueous dispersion liquid): 0.1177 parts
· RAPISOL (registered trademark) A-80 (anionic surfactant, manufactured by NOF Corporation, 80% aqueous solution): 0.0063 parts

### [Example 1]

The surface of the support 1 manufactured in Manufacturing Example 1 on the anodic oxide film side was coated with the undercoat layer coating liquid A such that the dry coating amount was 0.1 g/m², and dried at 120°C for 40 seconds to form an undercoat layer A.

The image recording layer coating liquid A prepared by the above-described method was bar-coated on the surface of the formed undercoat layer A, and dried in an oven at 120°C for 40 seconds to form an image recording layer A having a dry coating amount of 1.0 g/m², thereby obtaining a laminate in which the support 1, the undercoat layer A, and the image recording layer A were laminated.

Next, the surface of the formed image recording layer A was bar-coated with the following protective layer coating liquid A, and dried in an oven at 120°C for 60 seconds to form a protective layer A having a dry coating amount of 0.80 g/m², thereby preparing a planographic printing plate precursor in which the support, the undercoat layer A, the image recording layer A, and the protective layer A were laminated.

### [Examples 2 to 22 and Comparative Examples 1 to 4]

As shown in Table 2 described later, each of planographic printing plate precursors in which the support, the undercoat layer A, the image recording layer A, and the protective layer A were laminated was prepared according to the method described in Example 1, except that the supports 2 to 22 and 26 to 29 were used instead of the support 1.

### [Example 23]

A planographic printing plate precursor in which the support, the undercoat layer B, the image recording layer A, and the protective layer A were laminated was prepared according to the method described in Example 6, except that the support 23 was used instead of the support 1 and the undercoat layer B was formed using the undercoat layer coating liquid B instead of the undercoat layer coating liquid A.

### [Example 24]

A planographic printing plate precursor in which the support, the undercoat layer C, the image recording layer A, and the protective layer A were laminated was prepared according to the method described in Example 6, except that the support 24 was used instead of the support 1 and the undercoat layer C was formed using the undercoat layer coating liquid C instead of the undercoat layer coating liquid A.

### [Example 25]

A planographic printing plate precursor in which the support, the undercoat layer A, the image recording layer B, and the protective layer A were laminated was prepared according to the method described in Example 6, except that the support 25 was used instead of the support 1 and the image recording layer B was formed using the image recording layer coating liquid B instead of the image recording layer coating liquid A.

### [Measurement]

### <Density of micropores>

The density of micropores in the anodic oxide film of each support produced in Production Examples 1 to 29 was measured by the above-described method using FE-SEM.

The density (unit: pores/µm²) of micropores in the anodic oxide film measured for each support is shown in Table 2 described later.

### <Amount of specific Si atoms in coating surface>

The amount of specific Si atoms in the anodic oxide film of each support produced in Production Examples 1 to 29 was measured based on the X-ray fluorescence analysis method and the calibration curve method.

As a standard sample for creating a calibration curve, a sample obtained by uniformly adding an aqueous solution containing a known amount of silicon atoms to an area of 30 mmφ on an aluminum plate and drying the aqueous solution was used. The measurement conditions of the X-ray fluorescence analysis are shown below.

Fluorescent X-ray analysis device: RIX3000 manufactured by Rigaku Corporation, X-ray tube: Rh, measurement spectrum: Si-Kα, tube voltage: 50 kV, tube current: 50 mA, slit: COARSE, spectrometer crystal: RX4, detector: F-PC, analysis area: 30 mmφ, peak position (2θ): 144.75 deg., background (2θ): 140.70 deg. and 146.85 deg., and integration time: 80 seconds/sample

### [Evaluation]

The following performances were evaluated for the planographic printing plate precursors produced in each of Examples and Comparative Examples.

### <Evaluation of printing durability (1)>

The planographic printing plate precursor produced as described above was exposed using an exposure machine equipped with an infrared semiconductor laser ("Luxel PLATESETTER T-6000III" manufactured by FUJIFILM Corporation) under the conditions of an outer drum rotation speed of 1,000 rpm, a laser output of 70%, and a resolution of 2,400 dots per inch (dpi, 1 inch is 2.54 cm). The exposure image included a solid image and a 50% halftone dot chart of a 20 µm dot frequency modulation (FM) screen.

The obtained exposed planographic printing plate precursor was attached to a printing plate cylinder of a printer "SX-74" manufactured by Heidelberger Druckmaschinen AG without performing a development treatment. The printing press was connected to a 100 L dampening water circulation tank incorporating a nonwoven filter and a temperature controlling device. Using dampening water of Ecolity-2 (manufactured by FUJIFILM Corporation)/tap water = 2/98 (volume ratio) and Value-G (N) black ink (manufactured by DIC Corporation), the dampening water and the ink were supplied by a standard automatic printing start method of the printer SX-74, and on-press development was performed. Then, printing was performed on Tokubishi Art paper (manufactured by MITSUBISHI PAPER MILLS LIMITED., ream weight: 76.5 kg) at a printing speed of 10,000 sheets/hour. In order to evaluate the printing durability under a severe condition, the above printing was performed by setting a circumferential speed difference (slip rate) between the printing plate cylinder and the water feeder roller to 9%.

As the number of printed sheets increased, the image recording layer was gradually worn, and the ink density on the printed matter decreased. The number of printed sheets at a point in time at which the density of the solid image was visually observed to start to become lighter than that at the start of printing was defined as the number of evaluation printed sheets.

From the obtained number of evaluation printed sheets, the printing durability under a severe condition was evaluated according to the following evaluation standard. The printing durability is better as the number of evaluation printed sheets is larger.

### (Evaluation standard for evaluation of printing durability (1))

10: number of evaluation printed sheets was 100,000 or more.
9: number of evaluation printed sheets was 90,000 or more and less than 100,000.
8: number of evaluation printed sheets was 80,000 or more and less than 90,000.
7: number of evaluation printed sheets was 70,000 or more and less than 80,000.
6: number of evaluation printed sheets was 60,000 or more and less than 70,000.
5: number of evaluation printed sheets was 50,000 or more and less than 60,000.
4: number of evaluation printed sheets was 40,000 or more and less than 50,000.
3: number of evaluation printed sheets was 30,000 or more and less than 40,000.
2: number of evaluation printed sheets was 20,000 or more and less than 30,000.
1: number of evaluation printed sheets was less than 20,000.

### <Evaluation of printing durability (2)>

The planographic printing plate precursor produced as described above was exposed using an exposure machine equipped with an infrared semiconductor laser ("Luxel PLATESETTER T-6000III" manufactured by FUJIFILM Corporation) under the conditions of an outer drum rotation speed of 1,000 rpm, a laser output of 70%, and a resolution of 2,400 dots per inch (dpi, 1 inch is 2.54 cm). The exposure image included a solid image and a 50% halftone dot chart of a 20 µm dot frequency modulation (FM) screen.

The obtained exposed planographic printing plate precursor was attached to a plate cylinder of a printing machine ("LITHRONE26" manufactured by KOMORI Corporation) without performing a development treatment. Using dampening water of Ecolity-2 (manufactured by FUJIFILM Corporation)/tap water = 2/98 (volume ratio) and a turquoise special ink (ink having a calcium carbonate content of 20% by mass), the dampening water and the ink were supplied by a standard automatic printing start method of the printing machine, on-press development was performed, and then printing was performed on Tokubishi art paper (manufactured by MITSUBISHI PAPER MILLS LIMITED., ream weight: 76.5 kg) at a printing speed of 10,000 sheets per hour. In order to evaluate the printing durability under severe conditions, an ink having a calcium carbonate content of 20% by mass was used.

As the number of printed sheets increased, the image recording layer was gradually abraded, and thus the ink density on the printed material decreased. The number of printed sheets at a point in time at which the density of the solid image was visually observed to start to become lighter than that at the start of printing was defined as the number of evaluation printed sheets.

From the obtained number of evaluation printed sheets, the printing durability under a severe condition was evaluated according to the following evaluation standard. The printing durability is better as the number of evaluation printed sheets is larger.

### (Evaluation standard of evaluation of printing durability (2))

10: number of evaluation printed sheets was 100,000 or more.
9: number of evaluation printed sheets was 90,000 or more and less than 100,000.
8: number of evaluation printed sheets was 80,000 or more and less than 90,000.
7: number of evaluation printed sheets was 70,000 or more and less than 80,000.
6: number of evaluation printed sheets was 60,000 or more and less than 70,000.
5: number of evaluation printed sheets was 50,000 or more and less than 60,000.
4: number of evaluation printed sheets was 40,000 or more and less than 50,000.
3: number of evaluation printed sheets was 30,000 or more and less than 40,000.
2: number of evaluation printed sheets was 20,000 or more and less than 30,000.
1: number of evaluation printed sheets was less than 20,000.

### Evaluation of on-press developability

The obtained planographic printing plate precursor was exposed using an exposure machine ("Luxel PLATESETTER T-6000III" manufactured by FUJIFILM Corporation) equipped with an infrared semiconductor laser under conditions of an outer drum rotation speed of 1000 rpm, a laser output of 70%, and a resolution of 2,400 dpi. The exposure was performed by imagewise exposure including a solid image and a 50% halftone dot chart of a frequency modulation (FM) screen in the exposed image.

The imagewise-exposed planographic printing plate precursor was attached to a plate cylinder of a printing press "LITHRONE 26" (manufactured by Komori Corporation) without being subjected to a development treatment. Dampening water and ink were supplied thereto using a standard automatic printing start method of the above-described printing press, using dampening water of Ecolity-2 (manufactured by FUJIFILM Corporation)/tap water = 2/98 (volume ratio) and Values-G (N) black ink (manufactured by DIC Corporation), on-press development was performed, and then printing was performed on 100 sheets of TOKUBISHI art paper (ream weight: 76.5 kg, manufactured by MITSUBISHI PAPER MILLS LIMITED.) at a printing speed of 10,000 sheets/hour.

The number of sheets of printing paper required for the on-press development of the non-exposed portion of the 50% halftone dot chart on the printing press to a state in which the ink was not transferred to the halftone dot non-image area was measured (hereinafter, also referred to as "number of sheets of wasted paper"). The on-press developability was evaluated based on the following standard from the measured number of sheets of wasted paper. As described below, it can be said that the on-press developability is better as the number of sheets of wasted paper is smaller.

### (Evaluation standard for on-press developability)

10: number of sheets of wasted paper was 5 or less.
9: number of sheets of wasted paper was 6 to 10.
8: number of sheets of wasted paper was 11 to 15.
7: number of sheets of wasted paper was 16 to 19.
6: number of sheets of wasted paper was 20 to 25.
5: number of sheets of wasted paper was 26 to 29.
4: number of sheets of wasted paper was 30 to 34.
3: number of sheets of wasted paper was 35 to 39.
2: number of sheets of wasted paper was 40 to 50.
1: number of sheets of wasted paper was 51 or more.

### <Evaluation of ink repellency>

In the evaluation test of on-press developability, after a good printed matter in which the halftone non-image area was not transferred with ink was obtained, an evaluation test ink obtained by adding a varnish to an ink ("Fushion-EZ (S)" manufactured by DIC Corporation) was applied to the non-image area of the planographic printing plate, and printing was restarted. After the restart of printing, the number of sheets of printing paper (number of damaged sheets) required to obtain a good printed matter in which stains were not visible was measured.

The ink repellency was evaluated based on the following standard from the measured number of damaged sheets. As described below, it can be said that the ink repellency is better as the number of damaged sheets is smaller.

### (Evaluation standard of ink repellency)

10: number of sheets of wasted paper was 5 or less.
9: number of sheets of wasted paper was 6 to 10.
8: number of sheets of wasted paper was 11 to 15.
7: number of sheets of wasted paper was 16 to 19.
6: number of sheets of wasted paper was 20 to 25.
5: number of sheets of wasted paper was 26 to 29.
4: number of sheets of wasted paper was 30 to 34.
3: number of sheets of wasted paper was 35 to 39.
2: number of sheets of wasted paper was 40 to 50.
1: number of sheets of wasted paper was 51 or more.

Table 2 shows the configuration and evaluation results of the planographic printing plate precursors of each of Examples and each of Comparative Examples.

In the table, the column of "d1", the column of "d1ₘₐₓ", and the column of "D1" in the column of "Large-diameter pore portion" show the average diameter d1, the average maximum diameter d1ₘₐₓ, and the depth D1 of the large-diameter pore portion on the coating surface, respectively. In addition, the column of "d2" and the column of "D2" in the column of "Small-diameter pore portion" show the average diameter d2 and the depth D2 of the small-diameter pore portion at the communication position with the large-diameter pore portion, respectively.

In the table, "*1" means that the micropores formed in the anodic oxide film of the planographic printing plate precursors of Comparative Examples 1 and 2 are cylindrical hole portions having an average diameter of 0.012 µm on the coating surface and extending to a position at a depth of 1 µm from the coating surface.

**[Table 3]**

| Table 2 | Support | | | | | | | | Undercoat layer | Image recording layer | Evaluation | | | |
|---|---|---|---|---|---|---|---|---|---|---|---|---|---|---|
| | No. | Large-diameter pore portion | | | Small-diameter pore portion | | Micropore dencity | specific Si atom amount | | | printing durability | printing durability | on-press developability | ink repellency |
| | | d1 (µm) | d1max (µm) | D1 (µm) | d2 (µm) | D2 (µm) | (pores/µm²) | (mg) | | | (1) | (2) | | |
| Example 1 | 1 | 0.030 | 0.030 | 0.10 | 10 | 850 | 850 | 0.008 | A | A | 8 | 6 | 6 | 7 |
| Example 2 | 2 | 0.030 | 0.030 | 0.10 | 10 | 850 | 850 | 0.011 | A | A | 8 | 8 | 7 | 8 |
| Example 3 | 3 | 0.030 | 0.030 | 0.10 | 10 | 850 | 850 | 0.012 | A | A | 9 | 8 | 8 | 9 |
| Example 4 | 4 | 0.030 | 0.030 | 0.10 | 10 | 850 | 850 | 0.013 | A | A | 9 | 9 | 8 | 9 |
| Example 5 | 5 | 0.030 | 0.030 | 0.10 | 10 | 850 | 850 | 0.014 | A | A | 10 | 9 | 9 | 9 |
| Example 6 | 6 | 0.030 | 0.030 | 0.10 | 10 | 850 | 850 | 0.021 | A | A | 10 | 10 | 9 | 9 |
| Example 7 | 7 | 0.030 | 0.030 | 0.10 | 10 | 850 | 850 | 0.035 | A | A | 9 | 9 | 10 | 10 |
| Example 8 | 8 | 0.030 | 0.030 | 0.10 | 10 | 850 | 850 | 0.060 | A | A | 8 | 8 | 10 | 10 |
| Example 9 | 9 | 0.030 | 0.030 | 0.10 | 10 | 850 | 850 | 0.085 | A | A | 7 | 7 | 10 | 10 |
| Example 10 | 10 | 0.030 | 0.030 | 0.10 | 10 | 850 | 850 | 0.138 | A | A | 6 | 6 | 10 | 10 |
| Example 11 | 11 | 0.015 | 0.015 | 0.10 | 10 | 850 | 1950 | 0.021 | A | A | 5 | 5 | 8 | 9 |
| Example 12 | 12 | 0.022 | 0.022 | 0.10 | 10 | 850 | 1050 | 0.021 | A | A | 8 | 8 | 8 | 9 |
| Example 13 | 13 | 0.040 | 0.040 | 0.10 | 10 | 850 | 650 | 0.021 | A | A | 9 | 8 | 5 | 7 |
| Example 14 | 14 | 0.067 | 0.067 | 0.10 | 10 | 850 | 210 | 0.021 | A | A | 7 | 6 | 5 | 5 |
| Example 15 | 15 | 0.030 | 0.030 | 0.06 | 10 | 850 | 850 | 0.021 | A | A | 7 | 5 | 7 | 7 |
| Example 16 | 16 | 0.030 | 0.030 | 0.08 | 10 | 850 | 850 | 0.021 | A | A | 8 | 7 | 7 | 7 |
| Example 17 | 17 | 0.030 | 0.030 | 0.30 | 10 | 850 | 850 | 0.021 | A | A | 8 | 8 | 7 | 7 |
| Example 18 | 18 | 0.030 | 0.030 | 0.50 | 10 | 850 | 850 | 0.021 | A | A | 7 | 7 | 7 | 7 |
| Example 19 | 19 | 0.030 | 0.030 | 0.10 | 13 | 850 | 850 | 0.021 | A | A | 10 | 10 | 8 | 9 |
| Example 20 | 20 | 0.030 | 0.030 | 0.10 | 16 | 850 | 850 | 0.021 | A | A | 10 | 10 | 6 | 9 |
| Example 21 | 21 | 0.027 | 0.040 | 0.10 | 10 | 850 | 850 | 0.021 | A | A | 10 | 10 | 8 | 9 |
| Example 22 | 22 | 0.030 | 0.060 | 0.10 | 10 | 850 | 850 | 0.021 | A | A | 10 | 10 | 6 | 9 |
| Example 23 | 23 | 0.030 | 0.030 | 0.10 | 10 | 850 | 850 | 0.021 | B | A | 9 | 9 | 8 | 6 |
| Example 24 | 24 | 0.030 | 0.030 | 0.10 | 10 | 850 | 850 | 0.021 | C | A | 7 | 7 | 8 | 9 |
| Example 25 | 25 | 0.030 | 0.030 | 0.10 | 10 | 850 | 850 | 0.021 | A | B | 10 | 9 | 9 | 9 |
| Comparative Example 1 | 26 | ^{*}1 | | | | | 850 | 0.002 | A | A | 2 | 1 | 3 | 4 |
| Comparative Example 2 | 27 | ^{*}1 | | | | | 850 | 0.007 | A | A | 3 | 3 | 5 | 6 |
| Comparative Example 3 | 28 | 0.030 | 0.03 | 0.10 | 10 | 850 | 850 | 0.007 | A | A | 4 | 4 | 4 | 4 |
| Comparative Example 4 | 29 | 0.030 | 0.03 | 0.10 | 10 | 850 | 850 | 0.155 | A | A | 4 | 2 | 10 | 10 |

As is clear from Table 2, it was confirmed that the planographic printing plate precursors of Examples 1 to 25 had more excellent printing durability of the planographic printing plate precursor, as compared with the planographic printing plate precursors of Comparative Examples 1 and 2 in which the micropores did not have the specific structure, and the planographic printing plate precursors of Comparative Examples 3 and 4 in which the specific Si atom amount was less than 0.008 mg or more than 0.14 mg.

From the comparison of Examples 1 to 10, it was confirmed that, in a case where the specific Si atom amount was 0.008 to 0.138 mg, the printing durability of the planographic printing plate precursor was more excellent, and in a case where the specific Si atom amount was 0.012 to 0.035 mg, the printing durability of the planographic printing plate precursor was particularly excellent.

From the comparison of Examples 1 and 11 to 14, it was confirmed that, in a case where the average diameter d1 of the large-diameter pore portion on the coating surface was 0.022 to 0.040 µm, the printing durability of the planographic printing plate precursor was more excellent.

From the comparison of Examples 1 and 15 to 18, it was confirmed that, in a case where the depth D1 of the large-diameter pore portion from the coating surface was 0.08 to 0.30 µm, the printing durability of the planographic printing plate precursor was more excellent.

From the comparison of Examples 6, 23, and 24, it was confirmed that, in a case where the polymer having a polymerizable group was used for the undercoat layer, the printing durability of the planographic printing plate precursor was more excellent.

### Explanation of References

ta: anodic reaction time
tc: cathodic reaction time
tp: time taken for current to reach peak from 0
Ia: peak current on anode cycle side
Ic: peak current on cathode cycle side
10: planographic printing plate precursor
11: support
12: image recording layer
13: aluminum plate
14, 14A, 14B: anodic oxide film
20, 30: micropore
21, 31: film surface
22, 32: large-diameter pore portion
22A, 24A, 32A, 34A, 36A: bottom portion
23, 37, 39: communication position
24, 34: small-diameter pore portion
36: large-diameter pore portion upper portion
38: large-diameter pore portion lower portion
50: main electrolytic cell
51: AC power source
52: radial drum roller
53a, 53b: main pole
54: electrolytic solution supply port
55: electrolytic solution
56: slit
57: electrolytic solution passage
58: auxiliary anode
60: auxiliary anode cell
W: aluminum plate
610: anodization treatment device
612: power supply tank
614: electrolytic treatment tank
616: aluminum plate
618, 626: electrolytic solution
620: power supply electrode
622, 628: roller
624: nip roller
630: electrolytic electrode
632: tank wall
634: DC power source

## Claims

1. An on-press development type planographic printing plate precursor comprising:
a support; and
an image recording layer,
wherein the support has an aluminum plate and an anodized film disposed on the aluminum plate,
the anodized film has a plurality of micropores extending in a depth direction from a surface on a side of the image recording layer,
the micropores have large-diameter pore portions extending from the surface of the anodized film to a position at a depth of 0.05 to 0.50 µm and small-diameter pore portions communicating with bottom portions of the large-diameter pore portions and extending in the depth direction from communication positions,
an average diameter of the large-diameter pore portions on the surface of the anodized film is 0.015 to 0.070 µm, and
an average value of Si atomic amounts calculated in a case where a circular region having a diameter of 30 mm on the surface of the anodized film on the side of the image recording layer is measured by X-ray fluorescence analysis is 0.008 to 0.14 mg.

2. The on-press development type planographic printing plate precursor according to claim 1,
wherein a density of the micropores on the surface of the anodized film is 200 to 2,000 pores/µm2.

3. The on-press development type planographic printing plate precursor according to claim 1 or 2,
wherein a ratio of an average maximum diameter inside the large-diameter pore portions to the average diameter of the large-diameter pore portions on the surface of the anodized film is 1.2 to 10.0.

4. The on-press development type planographic printing plate precursor according to claim 1 or 2, further comprising:
an undercoat layer disposed between the support and the image recording layer,
wherein the undercoat layer contains a polymer having a support-adsorbing group and a hydrophilic group.

5. The on-press development type planographic printing plate precursor according to claim 4,
wherein the polymer has a support-adsorbing group, a hydrophilic group, and a polymerizable group.

6. The on-press development type planographic printing plate precursor according to claim 4,
wherein the hydrophilic group has a zwitterionic structure.

7. The on-press development type planographic printing plate precursor according to claim 1 or 2,
wherein the image recording layer contains an infrared absorber.

8. The on-press development type planographic printing plate precursor according to claim 7,
wherein the infrared absorber has a substituent that is cleaved by infrared rays or heat.

9. The on-press development type planographic printing plate precursor according to claim 1 or 2,
wherein the image recording layer contains a borate compound.

10. The on-press development type planographic printing plate precursor according to claim 1 or 2,
wherein the image recording layer contains an acid color forming agent.

11. The on-press development type planographic printing plate precursor according to claim 1 or 2,
wherein an average value of Si atomic amounts calculated in a case where a circular region having a diameter of 30 mm on the surface of the anodized film on the side of the image recording layer is measured by X-ray fluorescence analysis is 0.010 to 0.080 mg.

12. The on-press development type planographic printing plate precursor according to claim 1 or 2,
wherein an average value of Si atomic amounts calculated in a case where a circular region having a diameter of 30 mm on the surface of the anodized film on the side of the image recording layer is measured by X-ray fluorescence analysis is 0.011 to 0.060 mg.

13. A method of manufacturing a planographic printing plate, comprising:
an exposure step of exposing the image recording layer of the on-press development type planographic printing plate precursor according to claim 1 or 2 in an imagewise manner to form an exposed portion and a non-exposed portion; and
an on-press development step of supplying at least one of a printing ink or a dampening water on a printing press to remove the non-exposed portion of the imagewise-exposed image recording layer and to manufacture a planographic printing plate.

14. A printing method comprising:
an exposure step of exposing the image recording layer of the on-press development type planographic printing plate precursor according to claim 1 or 2 in an imagewise manner to form an exposed portion and a non-exposed portion;
an on-press development step of supplying at least one of a printing ink or a dampening water on a printing press to remove the non-exposed portion of the imagewise-exposed image recording layer and to manufacture a planographic printing plate; and
a printing step of performing printing using the manufactured planographic printing plate.
